(19) Europäisches Patentamt
European Patent Office
Office européen des brevets

(11) **EP 4 632 487 A1**

(12) **EUROPEAN PATENT APPLICATION**
published in accordance with Art. 153(4) EPC

(43) Date of publication:
**15.10.2025 Bulletin 2025/42**

(21) Application number: **23929949.8**

(22) Date of filing: **13.11.2023**

(51) International Patent Classification (IPC):
**G03F 7/20** (2006.01)

(52) Cooperative Patent Classification (CPC):
**G06F 30/27; G03F 7/20; G03F 7/705; G06F 17/18**

(86) International application number:
**PCT/CN2023/131292**

(87) International publication number:
**WO 2024/198380 (03.10.2024 Gazette 2024/40)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **28.03.2023 CN 202310371665**

(71) Applicant: **Tencent Technology (Shenzhen)
Company Limited
Shenzhen, Guangdong 518057 (CN)**

(72) Inventors:
• **MA, Xingyu**
**Shenzhen, Guangdong 518057 (CN)**
• **HAO, Shaogang**
**Shenzhen, Guangdong 518057 (CN)**
• **ZHANG, Shengyu**
**Shenzhen, Guangdong 518057 (CN)**

(74) Representative: **Nederlandsch Octrooibureau
P.O. Box 29720
2502 LS The Hague (NL)**

(54) **METHOD AND APPARATUS FOR DETERMINING PHOTORESIST MODEL FOR GENERATING PHOTORESIST PATTERN**

(57) A method and apparatus for determining a photoresist model for generating a photoresist pattern. The method comprises the following steps: 201, during any iteration process for training a photoresist model, acquiring a plurality of first parameter groups in a first parameter group set of the photoresist model; 202, fitting the photoresist model on the basis of the plurality of first parameter groups and a plurality of reference photoresist pattern matrixes to obtain a plurality of coefficients; 203, on the basis of the photoresist model with the determined coefficients and an error between a predicted photoresist pattern matrix of each of the plurality of first parameter groups and the reference photoresist pattern matrixes, predicting expected values of a plurality of second parameter groups, and adding a second parameter group the expected value of which meets a target condition to the first parameter group set to obtain an updated first parameter group set; and 204, when meeting an iteration stopping condition during the present iteration process, assigning to a plurality of parameters of the photoresist model respectively a plurality of candidate values in a parameter group having the minimum error in the updated first parameter group set.

FIG. 2

**Description**

RELATED APPLICATION

This application claims priority to Chinese Patent Application No. 202310371665.2, entitled "METHOD AND APPARATUS FOR DETERMINING PHOTORESIST MODEL FOR GENERATING PHOTORESIST PATTERN" filed on March 28, 2023, which is incorporated herein by reference in its entirety.

FIELD OF THE TECHNOLOGY

The present disclosure relates to the field of photolithography modeling technologies, and in particular, to a method and an apparatus for determining a photoresist model for generating a photoresist pattern.

BACKGROUND OF THE DISCLOSURE

A photolithography process is a most core, most complex, and most cost process in an integrated circuit manufacturing process. In the photolithography process, a pattern on a mask is replicated to a photoresist applied to a surface of a silicon wafer in a mode of optical exposure, and then the pattern is further transferred to the silicon wafer through processes such as developing and etching to obtain a photoresist pattern.

SUMMARY

Embodiments of the present disclosure provide a method and an apparatus for determining a photoresist model for generating a photoresist pattern, which improves accuracy of the photoresist model while ensuring optimization efficiency. Technical solutions are as follows:

According to an aspect, a method for determining a photoresist model for generating a photoresist pattern is provided. The method includes:

obtaining multiple model parameters from a model parameter group of a photoresist model in a current iterative process of training the photoresist model, wherein the photoresist model includes multiple pattern modules configured for generating a photoresist pattern, each of the multiple pattern modules corresponds to a respective reaction process of multiple photoresist reaction processes, each of the multiple pattern modules including a respective coefficient and a parameter configured for describing the reaction process, and the model parameter group is a subset of a candidate parameter group;

fitting the multiple model parameters and reference pattern matrixes to obtain a coefficient of each of the multiple pattern modules in the photoresist model;

determining a predicted pattern matrix of each of the multiple model parameters using the coefficients, predicting a optimization expected value of each of multiple candidate model parameters using difference between the predicted pattern matrix of each of the multiple model parameters and the reference pattern matrixes, wherein the optimization expected value indicates degree of optimization of the candidate model parameter for the photoresist model, and adding a target candidate model parameter with the optimization expected value satisfying a target condition among the multiple candidate model parameters to the model parameter group to update the model parameter group, wherein the candidate model parameter being a parameter other than the model parameter in the candidate parameter group; and

in response to that the current iterative process satisfies an iteration stop condition, respectively assigning, each of multiple candidate values in a parameter having a minimum difference in the updated model parameter group to a respective parameter of multiple parameters in the photoresist model.

According to another aspect, an apparatus for determining a photoresist model for generating a photoresist pattern is provided. The apparatus includes:

an obtaining module, configured to obtain multiple model parameters from a model parameter group of a photoresist model in a current iterative process of training the photoresist model, wherein the photoresist model includes multiple pattern modules configured for generating a photoresist pattern, each of the multiple pattern modules corresponds to a respective reaction process of multiple photoresist reaction processes, each of the multiple pattern modules including a respective coefficient and a parameter configured for describing the reaction process, and the model parameter group is a subset of a candidate parameter group;

a fitting module, configure to fit the multiple model parameters and reference pattern matrixes to obtain a coefficient of each of the multiple pattern modules in the photoresist model;

a determining module, configured determine a predicted pattern matrix of each of the multiple model parameters using the coefficients, predict a optimization expected value of each of multiple candidate model parameters using difference between the predicted pattern matrix of each of the multiple model parameters and the reference pattern matrixes, wherein the optimization expected value indicates degree of optimization of the candidate model parameter for the photoresist model, and add a target candidate model parameter with the optimization expected value satisfying a target condition among the multiple candidate model parameters to the model parameter group to update the model parameter group, wherein the candidate model parameter being a parameter other than the model parameter in the candidate parameter group; and

an assignment module, configured to: in response to that the current iterative process satisfies an iteration stop condition, respectively assign each of multiple candidate values in a parameter having a minimum difference in the updated model parameter group to a respective parameter of multiple parameters in the photoresist model.

In some embodiments, the determining module is configured to:

establish a Gaussian process model using the multiple model parameters and the difference between the predicted pattern matrix of each of the multiple model parameters and the reference pattern matrixes to obtain a mean function and a kernel function in the Gaussian process model, wherein the mean function and the kernel function is used to predict, using an input parameter, difference corresponding to the input parameter;

for each of the multiple candidate model parameters, determine, using the mean function and the kernel function, a mean value and a kernel function value of the candidate model parameter; and

determine the optimization expected value of the candidate model parameter using the mean value and the kernel function value of the candidate model parameter.

In some embodiments, the determining module is configured to:
add a candidate model parameter with the optimization expected value sorted in a first target digit among the multiple candidate model parameters to the model parameter group.
In some embodiments, the determining module is configured to:
add a candidate model parameter with the optimization expected value greater than a preset optimization expected value among the multiple candidate model parameters to the model parameter group.
In some embodiments, the obtaining module is configured to: cluster multiple parameters in the candidate parameter group to obtain multiple categories, and add a parameter closest to a cluster center of the category in each category to the model parameter group to obtain the model parameter group in the first iterative process.
In some embodiments, the fitting module is configured to: perform least square fitting on the multiple model parameters and the reference pattern matrixes to obtain the coefficient of each of the multiple pattern modules.
In some embodiments, the apparatus further includes:

a difference value determining module, configured to: for each of the multiple model parameters in the model parameter group, determine difference values between the predicted pattern matrix of the model parameter and the multiple reference pattern matrixes; and

a difference determining module, configured to determine a root-mean-square error among the multiple difference values as the difference corresponding to the model parameter, wherein each of the multiple difference values is a difference value between the predicted pattern matrix of the model parameter and each of the multiple reference pattern matrixes.

In some embodiments, the apparatus further includes:
a sampling module, configured to sample from a parameter space of the multiple parameters in the photoresist model using value ranges of the multiple parameters to obtain the candidate parameter group.
In some embodiments, the apparatus further includes:

a comparison module, configured to: compare a minimum difference corresponding to a parameter in the candidate model parameter group with a minimum difference corresponding to a parameter in a iterated model parameter group, updating the value ranges of the multiple parameters in the parameter space using a comparison result, re-determining a candidate parameter group using updated value ranges, and re-iteratively determining the photoresist model using the re-determined candidate parameter group, wherein the candidate model parameter group is a model parameter group in a first iterative process, and the iterated model parameter group is a model parameter group obtained after iterating the model parameter group for multiple times; and

an iteration module, configured to iteratively perform operations of comparing a minimum difference corresponding to a parameter in the candidate model parameter group with a minimum difference corresponding to a parameter in a iterated model parameter group, updating the value ranges of the multiple parameters in the parameter space using a comparison result, re-determining a candidate parameter group using updated value ranges, and re-iteratively determining the photoresist model using the re-determined candidate parameter group, and using, when the current iterative process satisfies a preset condition, the photoresist model obtained in the current iteration as a target photoresist model.

In some embodiments, the comparison module is configured to:

reduce, when the minimum difference corresponding to the parameter in the candidate model parameter group is less than or equal to the minimum difference corresponding to the parameter in the iterated model parameter group, the value ranges of the multiple parameters in the parameter space according to a preset proportion by using the parameter corresponding to the minimum difference in the candidate model parameter group as a center; and

increase, when the minimum difference corresponding to the parameter in the candidate model parameter group is greater than the minimum difference corresponding to the parameter in the iterated model parameter group, the value ranges of the multiple parameters in the parameter space according to a preset proportion by using the parameter corresponding to the minimum difference in the iterated model parameter group as a center

According to another aspect, a computer device is provided. The computer device includes a processor and a memory. The memory is configured to store at least one computer program, and the at least one computer program is loaded and executed by the processor to perform the method for determining a photoresist model for generating a photoresist pattern in the embodiments of this application.

According to another aspect, a computer-readable storage medium is provided. The computer-readable storage medium stores at least one computer program. The at least one computer program is loaded and executed by a processor to implement the method for determining a photoresist model for generating a photoresist pattern in the embodiments of this application.

According to another aspect, a computer program product is provided. The computer program product is stored in a computer-readable storage medium. A processor of a computer device reads the computer program from the computer-readable storage medium, and the processor executes the computer program, to enable the computer device to perform the method for determining a photoresist model for generating a photoresist pattern according to any of the foregoing implementations.

The embodiments of the present disclosure provide a method for determining a photoresist model for generating a photoresist pattern. In the method, a predicted pattern matrix of an existing parameter in a model parameter group is determined through the photoresist model, and then degree of optimization of the candidate model parameter for the photoresist model is predicted based on difference between the predicted pattern matrix and a reference pattern matrix, so that a parameter having good optimization degree in the candidate model parameters can be selected to be added to the model parameter group. According to the method, the model parameter group is determined iteratively, and when a data volume in the model parameter group is ensured, a parameter which can effectively optimize a photoresist model can be found from the model parameter group, thereby obtaining the photoresist model that can accurately predict a photoresist pattern. In addition, according to the method, a coefficient of the photoresist model is obtained by fitting the parameter and the reference matrix, that is, the parameter and the coefficient of the photoresist model are optimized collaboratively, thereby improving accuracy of the photoresist model while ensuring optimization efficiency.

BRIEF DESCRIPTION OF THE DRAWINGS

To describe technical solutions in embodiments of the present disclosure more clearly, the following briefly introduces accompanying drawings required for descriptions in the embodiments.

FIG. 1 is a schematic diagram of an implementation environment according to an embodiment of this application.

FIG. 2 is a flowchart of a method for determining a photoresist model for generating a photoresist pattern according to an embodiment of this application.

FIG. 3 is a flowchart of another method for determining a photoresist model for generating a photoresist pattern according to an embodiment of this application.

FIG. 4 is a flowchart of another method for determining a photoresist model for generating a photoresist pattern according to an embodiment of this application.

FIG. 5 is a flowchart of another method for determining a photoresist model for generating a photoresist pattern according to an embodiment of this application.

FIG. 6 is a schematic diagram of an error of a photoresist pattern matrix according to an embodiment of this application.

FIG. 7 is a comparison diagram between a predicted photoresist pattern and a reference photoresist pattern according to an embodiment of this application.

FIG. 8 is a block diagram of an apparatus for determining a photoresist model for generating a photoresist pattern according to an embodiment of this application.

FIG. 9 is a block diagram of a terminal according to an embodiment of this application.

FIG. 10 is a block diagram of a server according to an embodiment of this application.

DESCRIPTION OF EMBODIMENTS

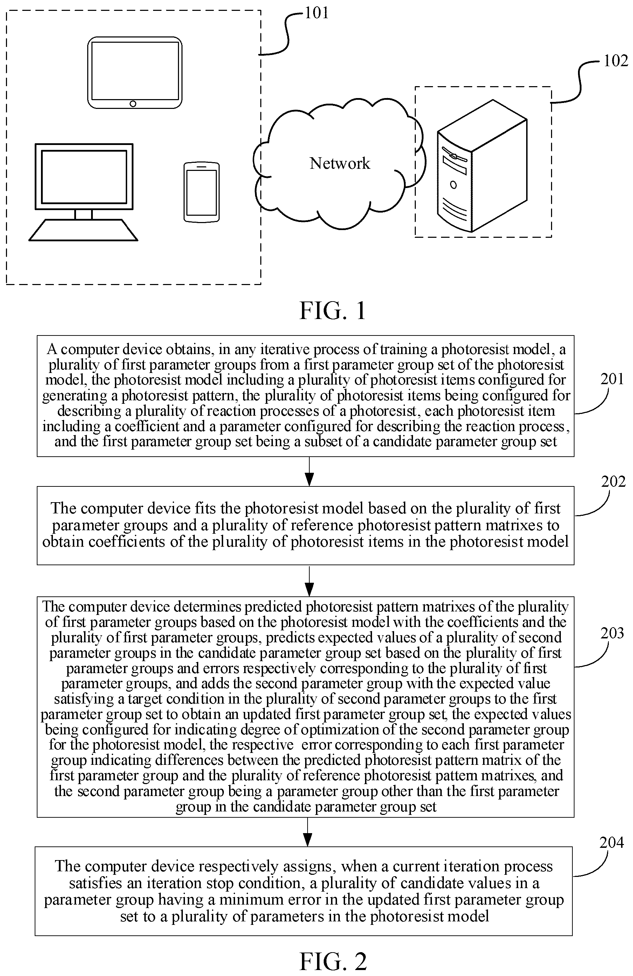

To make objectives, technical solutions, and advantages of the present disclosure clearer, the following further describes implementations of the present disclosure in detail with reference to accompanying drawings.
In this application, terms "first", "second", and the like are configured for distinguishing between same items or similar items that have basically same actions and functions. "First", "second", and "nth" do not have logical or time sequence dependency, and a number and an execution sequence are not limited either.
In this application, a term "at least one" refers to one or more, and "a plurality of" refers to two or more.
Information (including, but not limited to, user device information, user personal information, the like), data (including, but not limited to, data configured for analyzing, data configured for storage, data configured for displaying, and the like), and signals involved in the present disclosure are all authorized by a user or all parties, and collection, use, and processing of relevant data have to comply with relevant laws, regulations, and standards of relevant countries and regions. For example, parameter and the like involved in the present disclosure are obtained under full authorization.
A photolithography process can be described by using a photoresist model. The photoresist model describes a process in which photos in an optical latent image excite a photoresist to generate a series of photochemical reaction, and after baking and developing processes, a photoresist pattern is finally left.
In a development process of the photographing process, new photographing technologies and photoresists always appear, and parameters in an original photoresist model are no longer applicable to the new photographing technologies and photoresists. Therefore, the parameters in the photoresist model need to be optimized to obtain a new photoresist model with high accuracy.
The following introduces an implementation environment involved in this application.
A method for determining a photoresist model for generating a photoresist pattern according to this embodiment of the present disclosure can be performed by a computer device. The computer device can be a server or a terminal. The following introduces a schematic diagram of an implementation environment of a method for determining a photoresist model for generating a photoresist pattern according to this embodiment of this application. FIG. 1 is a schematic diagram of an implementation environment a method for determining a photoresist model for generating a photoresist pattern according to an embodiment of this application. The implementation environment includes a terminal 101 and a server 102. The terminal 101 and the server 102 can be directly or indirectly connected in a wired or wireless communication protocol, which is not limited in this application. In some embodiments, a target application for performing a photolithography process is installed on the terminal 101, the server 102 is a background server of the target application, and the server 102 is configured to train a photoresist model to which the photographing process is applied. The terminal 101 is embedded into the photoresist model, and is configured to predict a photoresist pattern based on the photoresist model; or the terminal 101 predicts a photoresist pattern through the photoresist model on the server 102.

In some embodiments, the terminal 101 can be a smartphone, a tablet computer, a laptop computer, a desktop computer, a smart voice interaction device, a smart home appliance, a vehicle terminal, an aircraft, a virtual reality (VR) apparatus, an augmented reality (AR) apparatus, or the like, but is not limited thereto. In some embodiments, the server 102 can be an independent server, or can be a server cluster composed of a plurality of servers or a distributed system, or can be a cloud server that provides basic cloud computing services such as a cloud service, a cloud database, cloud computing, a cloud function, cloud storage, a network service, cloud communication, a middleware service, a domain name service, a security service, a content delivery network (CDN), a big data platform, and an artificial intelligence (AI) platform. In some embodiments, the server 102 is responsible for primary computing work, and the terminal 101 is responsible for secondary computing work; or the server 102 is responsible for secondary computing work, and the terminal 101 is responsible for primary computing work; or a distributed computing architecture may be used between the server 102 and the terminal 101 for collaborative computing.

FIG. 2 is a flowchart of a method for determining a photoresist model for generating a photoresist pattern according to an embodiment of this application. The method is performed by a computer device. The method includes the following operations.

201: A computer device obtains, in any iterative process of training a photoresist model, a plurality of first parameter groups in a first parameter group set of the photoresist model, the photoresist model including a plurality of photoresist items configured for generating a photoresist pattern, each the plurality of photoresist items being configured for describing a plurality of reaction processes of a photoresist, each photoresist item including a coefficient and a parameter configured for describing the reaction process, and the first parameter group set being a subset of a candidate parameter group set.

In this embodiment of this application, the first parameter group is also referred to as the model parameter, the first parameter group set is also referred to as the model parameter group, and the candidate parameter group set is also referred to as the candidate parameter group. The photoresist model includes a plurality of photoresist items that are also referred to as pattern modules. The plurality of photoresist items are configured for describing the plurality of reaction processes of the photoresist. The reaction processes are processes of physical reaction or chemical reaction. For example, the physical reaction or the chemical reaction includes molecular diffusion, acid-base neutralization reaction, or the like. The plurality of parameters of the photoresist model are parameters configured for describing the reaction process in the plurality of photoresist items, and each photoresist item has a coefficient. In this embodiment of this application, the photoresist model is configured for predicting the photoresist pattern based on a given light intensity distribution.

202: The computer device fits the photoresist model based on the plurality of first parameter groups and a plurality of reference photoresist pattern matrixes to obtain coefficients of the plurality of photoresist items in the photoresist model.

In this embodiment of this application, the reference photoresist pattern matrix that is also referred to as the reference pattern matrix is obtained based on experimental measurement data, the reference photoresist pattern matrix is configured for describing a reference photoresist pattern, and a plurality of elements in the reference photoresist pattern matrix respectively represent pixel values at a plurality of pixel positions in the reference photoresist pattern. The reference photoresist pattern is an actual exposure pattern on a wafer, that is, the reference photoresist pattern is a photoresist pattern that is expected to be obtained through the photoresist model.

In this embodiment of this application, that the computer device fits the photoresist model based on the plurality of first parameter groups and a plurality of reference photoresist pattern matrixes refers to that: the plurality of first parameter groups and the plurality of reference photoresist pattern matrixes are combined pairwise to obtain a plurality of known quantity arrays, and each known quantity array includes one first parameter group and one reference photoresist pattern matrix. The plurality of known quantity arrays are respectively substituted into the photoresist model to fit a plurality of unknown quantities in the photoresist model, that is, coefficients of a plurality of photoresist models.

203: The computer device determines predicted photoresist pattern matrixes of the plurality of first parameter groups based on the photoresist model with the determined coefficients and the plurality of first parameter groups, predicts expected values of a plurality of second parameter groups in the candidate parameter group set based on the plurality of first parameter groups and errors respectively corresponding to the plurality of first parameter groups, and adds a second parameter group with the expected value satisfying a target condition in the plurality of second parameter groups to the first parameter group set to obtain an updated first parameter group set, the expected value being configured for indicating degree of optimization of the second parameter group for the photoresist model, the error corresponding to each of the plurality of first parameter groups being indicating differences between the predicted photoresist pattern matrix of the first parameter group and the plurality of reference photoresist pattern matrixes, and the second parameter group being a parameter group in the candidate parameter group set other than the first parameter group.

In this embodiment of this application, the second parameter group is also referred to as the candidate model parameter, the expected value is also referred to as the optimization expected value, the error corresponding to each of the plurality of first parameter groups is also referred to as the difference corresponding to each of the plurality of first parameter groups, the differences between the predicted photoresist pattern matrix of the first parameter group and the plurality of reference photoresist pattern matrixes is also referred to as the difference values between the predicted photoresist pattern matrix of the first parameter group and the plurality of reference photoresist pattern matrixes, and the second parameter group with the expected value satisfying a target condition is also referred to as the target candidate model parameter. The predicted photoresist pattern matrix that is also referred to as the predicted pattern matrix is configured for describing the predicted photoresist pattern, and the plurality of elements in the predicted photoresist pattern respectively represent pixel values at a plurality of pixel positions in the predicted photoresist pattern. The updated first parameter group set is a first parameter group set used in a next iterative process.

204: The computer device respectively assigns, when a current iterative process satisfies an iteration stop condition, a plurality of candidate values in the parameter group having a minimum error in the updated first parameter group set to a plurality of parameters in the photoresist model.

In this embodiment of this application, the iteration stop condition is that a number of iterations reaches a preset number of times, or that an error corresponding to the parameter group having the minimum error reaches a preset error. Herein, the parameter group is also referred as to the parameter. This is not specifically limited herein. The preset number of times and the preset error can be set and modified as required. The computer device iteratively performs the foregoing operations 201 to 203, and obtains an optimal parameter group by continuously iterating the first parameter group set, to obtain a photoresist model with high accuracy.

In this embodiment of this application, the computer device re-performs operations 202 to 203 based on the first parameter group set obtained in the current iteration, determines the parameter group corresponding to the minimum error in the first parameter group set obtained in the current iteration, and respectively assigns the plurality of candidate values in the parameter group to the plurality of parameters in the photoresist model with the determined coefficients in operation 202, that is, a process of determining the photoresist model is implemented.

The embodiments of the present disclosure provide a method for determining a photoresist model for generating a photoresist pattern. In the method, a predicted photoresist pattern matrix of an existing parameter in a first parameter group set is determined through the photoresist model, and then degree of optimization of the second parameter group for the photoresist model is predicted based on an error between the predicted photoresist pattern matrix and a reference photoresist pattern matrix, so that a second parameter group having good optimization degree in the plurality of second parameter groups can be selected to be added to the first parameter group set. According to the method, the first parameter group set is updated iteratively, and when a data volume in the first parameter group set is ensured, a parameter group which can effectively optimize a photoresist model can be found from the first parameter group set, thereby obtaining the photoresist model that can accurately predict a photoresist pattern. In addition, according to the method, a coefficient of the photoresist model is obtained by fitting the parameter group and the reference photoresist pattern, that is, the parameter and the coefficient of the photoresist model are optimized collaboratively, thereby improving accuracy of the photoresist model while ensuring optimization efficiency.

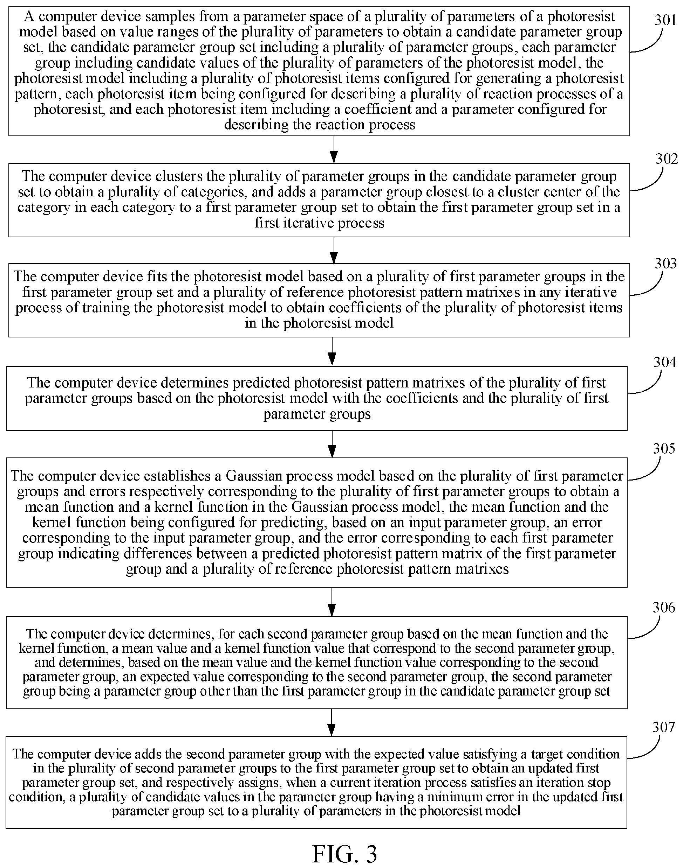

FIG. 2 is a basic process of determining a photoresist model. The process of determining the photoresist model is further described below based on FIG. 3. FIG. 3 is a flowchart of a method for determining a photoresist model for generating a photoresist pattern according to an embodiment of this application. The method is performed by a computer device. The method includes the following operations.

301: A computer device samples from a parameter space of a plurality of parameters in a photoresist model based on value ranges of the plurality of parameters to obtain the candidate parameter group, the candidate parameter group set including a plurality of parameter groups, each parameter group including candidate values of the plurality of parameters of the photoresist model, the photoresist model including a plurality of photoresist items configured for generating a photoresist pattern, the plurality of photoresist items being configured for describing a plurality of reaction processes of a photoresist, and each photoresist item including a coefficient and a parameter configured for describing the reaction process.

In this embodiment of this application, the computer device first obtains a framework of the photoresist model. Optionally, the framework of the photoresist model is a mathematical formula framework, for example, referring to the following formula (1).

$$\mathrm{RI} = \alpha_1 \mathrm{conv}\big(\max(I - t_1, 0), G(\delta_1)\big) + \alpha_2 \mathrm{conv}\big(\max(t_2 - I, 0), G(\delta_2)\big) + \alpha_3 \mathrm{conv}\big(I, G(\delta_3)\big) +$$
$$\alpha_4 \mathrm{conv}\left(I_x^2 + I_y^2, G(\delta_4)\right) \qquad (1);$$

where RI represents a matrix output by the photoresist model, each of $\mathrm{conv}(\max(I - t_1, 0), G(\delta_1))$, $\mathrm{conv}(\max(t_2 - I, 0), G(\delta_2))$, $\mathrm{conv}(I, G(\delta_3))$, and $\mathrm{conv}\left(I_x^2 + I_y^2, G(\delta_4)\right)$ represents one photoresist item, and each of $\alpha_1, \alpha_2, \alpha_3$, and $\alpha_4$ represents

a coefficient of each photoresist item. Each of $\delta_1$ $\delta_2$, $\delta_3$, and $\delta_4$ represents a standard deviation of a Gaussian distribution function G in a photoresist item, that is, a parameter in the photoresist item. Each of $t_1$ and $t_2$ represents a threshold of a truncation function max (a maximum value) in a photoresist item, that is, a parameter in the photoresist item, $\delta_1$, $\delta_2$, $\delta_3$, $\delta_4$, $t_1$, and $t_2$ are the plurality of parameters to be determined in the photoresist model. In some embodiments, the plurality of parameters have initial values and initial value ranges, and the plurality of parameters are to be optimized. I represents a light intensity distribution, that is, a distribution of light of a photographing machine on a photoresist on a wafer, the light intensity distribution is usually obtained through calculation of an optical model or experimental measurement. Each of $I_x^2$

and $I_y^2$ represents a first-order partial derivative of the light intensity distribution along an X axis and a Y axis, and conv represents a convolution operation.

A plurality of elements in the matrix output by the photoresist model respectively represent pixel values at a plurality of pixel positions in the photoresist pattern. The computer device performs binarization processing on the matrix output by the photoresist model through the following formula (2) to obtain a predicted photoresist pattern matrix.

$$R = \begin{cases} 1, RI \geq t \\ 0, RI < t \end{cases} \quad (2);$$

where R represents the predicted photoresist pattern matrix, and RI represents a matrix output by the photoresist model, and $t$ indicates a pixel threshold. Through the formula (2), an element with a corresponding pixel value greater than or equal to the pixel threshold in the matrix output by the photoresist model is assigned to 1, and an element with a corresponding pixel value less than the pixel threshold is assigned to 0.

In this embodiment of this application, the parameter space is multidimensional parameter space, and can cover value ranges of the plurality of parameters. The value ranges of the plurality of parameters may be the same or different. This is not specifically limited herein. For example, if the photoresist model includes two parameters, the parameter space is a two-dimensional parameter space. Optionally, the value ranges of the two parameters are respectively [0, 1] and [2, 3], and correspondingly, the value range covered by the parameter space in one dimension is not less than [0, 1], and the value range covered by the parameter space in the other dimension is not less than [2, 3].

In this embodiment of this application, the computer device can perform sampling in the parameter space in a Latin hypercubic sampling mode, or can perform sampling in the parameter space in a random sampling mode. In this embodiment of this application, an example in which sampling is performed in the Latin hypercube sampling mode is used for description.

In a process of sampling in a Latin hypercubic sampling mode, the computer device selects L sample points for each dimension in the parameter space with a value dimension of K, and divides values of the dimension into L intervals that have a same value length and that do not overlap with each other. A sample point is randomly extracted from each interval, and then the sample points randomly extracted in the plurality of dimensions are cross-combined to obtain the plurality of parameters in the candidate parameter group set, where both K and L are integers greater than 0, and K represents a dimension of the plurality of parameters. In this embodiment of this application, sampling is performed based on the Latin hypercube sampling mode. Compared with random sampling, samples obtained by sampling are more evenly distributed, ensuring comprehensiveness of the sampled samples.

302: The computer device clusters the plurality of parameters in the candidate parameter group set to obtain a plurality of categories, and adds a parameter group closest to a cluster center of the category in each category to the first parameter group set to obtain the first parameter group set in the first iterative process.

In some embodiments, the computer device performs clustering based on a K-means clustering algorithm. The computer device inputs the plurality of parameters in the candidate parameter group set into the K-means algorithm, and specifies a number N of cluster centers, where N is an integer greater than 1. A principle of the K-means algorithm is to divide data into N categories according to a Euclidean space distance between the data, data points within a category are connected together as much as possible, and a distance between the data points between the categories is as large as possible. That is, the K-means algorithm minimizes a square error by constantly changing a position of the cluster center. For example, refer to the following formula (3).

$$\text{error} = \sum_{i=1}^{N} \sum_{x \in C_i} |x - \mu_i|^2, \quad \mu_i = \frac{1}{|C_i|} \sum_{x \in C_i} x \quad (3);$$

where N represents a number of cluster centers, x represents a parameter group in the candidate parameter group set, i represents an $i^{th}$ category, and i is an integer greater than 1, $\mu_i$ represents the cluster center of an i category, $C_i$ represents a number of data samples in the $i^{th}$ category, and error represents the square error. When the cluster centers of N categories do not change any longer, that is, the square error converges to a minimum, the K-means algorithm outputs N optimal cluster centers and a category where each parameter group is located, and the parameter group closest to the cluster center of the category in each category is added to the first parameter group set to obtain the first parameter group set in the first iteration process.

In some other embodiments, the computer device can further add a first target number of parameters closest to the cluster center of the category in each category to the first parameter group set to increase a data volume of the parameter groups in the first parameter group set.

In this embodiment of this application, the first parameter group set in the first iterative process is obtained based on the foregoing operation 302. In this embodiment, the parameter group closest to the cluster center in each category is selected to be added to the first parameter group set, so that the parameter group in the first parameter group set has good representativeness and has high accuracy. The foregoing operation 302 is merely an optional implementation of obtaining the first parameter group set in the first iterative process. In this embodiment of this application, the first parameter group set can alternatively be obtained in another optional implementation. This is not specifically limited herein. For example, the plurality of parameters are randomly selected from the candidate parameter group set to be added to the first parameter group set to obtain the first parameter group set in the first iterative process.

In this embodiment of this application, a first parameter group set used in any iterative process other than the first parameter group set in the first iterative process is obtained through the following operations 303 to 307. The computer device iteratively performs the following operations 303 to 307 until any iterative process reaches an iteration stop condition.

303: The computer device fits the photoresist model based on a plurality of first parameter groups in the first parameter group set and a plurality of reference photoresist pattern matrixes in any iterative process of training the photoresist model to obtain coefficients of the plurality of photoresist items in the photoresist model.

In some embodiments, the foregoing process in which the computer device fits the photoresist model based on the plurality of first parameter groups and the plurality of reference photoresist pattern matrixes to obtain coefficients of the plurality of photoresist items in the photoresist model includes the following operations. The computer device performs least square fitting on the photoresist model based on the plurality of first parameter groups and the plurality of reference photoresist pattern matrixes to obtain coefficients of the plurality of photoresist items. In this embodiment of this application, the least square fitting is performed through the reference photoresist pattern matrix to obtain a coefficient in the photoresist model. Because the reference photoresist pattern matrix has good reality, the coefficient with high accuracy can be obtained by fitting.

In some embodiments, the computer device performs fitting by using a least square method with a constraint condition. The constraint condition refers to defining a range of a coefficient of each photoresist item. For example, in the formula (1), absolute values of coefficients of the first photoresist item and the second photoresist item are not greater than 5, and absolute values of coefficients of the third photoresist item and the fourth photoresist item are not greater than 1. The least square method with the constraint condition can satisfy a constraint on each coefficient.

In this embodiment of this application, one reference photoresist pattern matrix corresponds to one light intensity distribution. For each first parameter group, the computer device substitutes the first parameter group, one reference photoresist pattern matrix, and the light intensity corresponding to the reference photoresist pattern matrix into the photoresist model to obtain a photoresist model with a coefficient to be determined. Similarly, each reference photoresist pattern matrix and the light intensity corresponding to the reference photoresist pattern matrix are substituted into the photoresist model to obtain a photoresist model with a plurality of coefficients to be determined corresponding to the first parameter group. Then, the least square fitting with the constraint condition is performed based on the photoresist model with the plurality of coefficients to be determined respectively corresponding to the plurality of first parameter groups to obtain the plurality of coefficients.

304: The computer device determines predicted photoresist pattern matrixes of the plurality of first parameter groups based on the photoresist model with the determined coefficients and the plurality of first parameter groups.

In this embodiment of this application, the computer device substitutes the coefficients of the plurality of photoresist items into the photoresist model to obtain the photoresist model with the determined coefficients. For each first parameter group, the computer device substitutes the first parameter group into the photoresist model with the determined coefficients, and solves the photoresist model to obtain the predicted photoresist pattern matrix of the first parameter group. That is, the predicted photoresist pattern matrix of each first parameter group is obtained through the foregoing formulas (1) and (2).

305: The computer device establishes a Gaussian process model based on the plurality of first parameter groups and errors respectively corresponding to the plurality of first parameter groups to obtain a mean function and a kernel function in the Gaussian process model, the mean function and the kernel function being configured for predicting, based on an input parameter group, an error corresponding to the input parameter group, and an error corresponding to each first parameter group indicating difference values between a predicted photoresist pattern matrix of the first parameter group and a plurality of reference photoresist pattern matrixes.

In this embodiment of this application, the Gaussian process model establishes a mapping relationship between the parameter group and the error. The Gaussian process may be described as Error(x)~GP($\mu$(x), $\sigma$(x)), Error(x) represents an error, $\mu$(x) represents a mean function, $\sigma$(x) represents a kernel function, and xrepresents any parameter group. The Gaussian process model is a set of random variables satisfying a joint Gaussian distribution, and an overall root-mean-square error of the first parameter group set is described by using the Gaussian process model. $\mu$(x) and $\sigma$(x) are respectively configured for describing a mean value and uncertainty of the plurality of parameters in the first parameter group set. The computer device establishes the Gaussian process model through a Gaussian process regression algorithm. The Gaussian process regression algorithm is a non-parameter regression algorithm and aims at establishing a function distribution consistent with the first parameter group set.

In some embodiments, a process of determining the error corresponding to each parameter group includes the following operations: for each first parameter group in the first parameter group set, the computer device determines difference values between the predicted photoresist pattern matrix of the first parameter group and the plurality of reference photoresist pattern matrixes; and the computer device uses a root-mean-square error among a plurality of differences as the error corresponding to the first parameter group, where the plurality of difference values are the difference values between the predicted photoresist pattern matrix of the first parameter group and the plurality of reference photoresist pattern matrixes. In this embodiment of this application, the error corresponding to the first parameter group is a root-mean-square error among a plurality of errors, so that accuracy of the error corresponding to each parameter group is high.

306: The computer device determines, for each second parameter group based on the mean function and the kernel function, a mean value and a kernel function value that correspond to the second parameter group, and determines, based on the mean value and the kernel function value corresponding to the second parameter group, an expected value corresponding to the second parameter group, the second parameter group being a parameter group other than the first parameter group in the candidate parameter group set.

In some embodiments, the computer device determines the expected value through an expected improvement function. For example, for the expected improvement function, refer to the following formula (4).

$$\mathrm{EI}(x) = \sigma(x)[z\Phi(z) + \varphi(z)], \; z = (f^{\min} - \mu(x))/\sigma(x) \qquad (4);$$

where EI(x) represents an expected value, z represents an intermediate parameter, $\Phi$(z) represents an accumulated density function of a normal distribution function, $\varphi$(z) represents a probability density function of the normal distribution function, and $f^{\min}$ represents a minimum error corresponding to a parameter group in a current first parameter group set. A first term ($\sigma$(x)z$\Phi$(z)) in the formula (4) tends to find a result better than a current optimal value, indicating a local area search process. The second term ($\sigma$(x)$\varphi$(z)) in the formula (4) tends to find that the second parameter group has a region with higher uncertainty, indicating a global search process. In this embodiment, local optimization and global search can be better considered based on the expected improvement function, and then a parameter group with a high optimization value can be found based on the obtained expected value.

In some embodiments, the computer device uses an n-dimensional square exponential function as the kernel function, where n is an integer greater than 0, for example, referring to the kernel function shown in the following formula (5).

$$k(x, x') = \exp\left\{-\frac{\sum_{i=1}^{n}|x_i - x_i'|^2}{\sigma_i^2}\right\} \qquad (5);$$

where k(x, x') represents the kernel function value, x and x' represent two different parameter groups, $x_i$ represents an $i^{th}$ parameter in a parameter group set x, n represents a dimension of x, and $\sigma_i^2$ represents a hyper-parameter obtained through maximum likelihood estimation.

In this embodiment of this application, a process of predicting expected values of the plurality of second parameter groups in the candidate parameter group set based on the plurality of first parameter groups and the errors respectively corresponding to the plurality of first parameter groups is implemented through the foregoing operations 305 to 306. In this embodiment, a mapping relationship between the parameter group and the error is established through a Gaussian process model of Bayesian active learning. A parameter group that can effectively optimize the photoresist model is determined based on a function in the mapping relationship, so that the parameter group that can effectively optimize the photoresist model can be found, thereby improving efficiency and accuracy of optimizing the photoresist model. Optionally, the second parameter group is stored in a remaining parameter group set.

The foregoing operations 305 to 306 are merely an optional implementation of determining the expected value. In this embodiment of this application, the expected value can alternatively be determined through another optional implementation. This is not specifically limited herein. For example, the error corresponding to the parameter group is directly determined based on the Gaussian process model, the error is used as the expected value, and correspondingly, the parameter group corresponding to a small error is added to the first parameter group set.

307: The computer device adds a second parameter group with the expected value satisfying a target condition in the plurality of second parameter groups to the first parameter group set to obtain an updated first parameter group set, and respectively assigns, when a current iterative process satisfies an iterative stop condition, a plurality of candidate values in the parameter group having a minimum error in the updated first parameter group set to a plurality of parameters in the photoresist model.

In this embodiment of this application, the foregoing process in which the computer device adds the second parameter group with the expected value satisfying a target condition in the plurality of second parameter groups to the first parameter group set includes the following two implementations. In an implementation, the computer device adds a second parameter group with the expected value sorted in a first target digit in the plurality of second parameter groups to the first parameter group set. In another implementation, the computer device adds a second parameter group with the expected value greater than a preset expected value in the plurality of second parameter groups to the first parameter group set. Both of the two implementations implement that a second parameter group having a large expected value is added to the first parameter group set, and the second parameter group having the large expected value has high degree of optimization for the photoresist model. In this way, the photoresist model can be effectively optimized based on the second parameter group added to the first parameter group set, thereby obtaining the photoresist model with high accuracy.

In some embodiments, the computer device directly and respectively assigns the plurality of candidate values in the parameter group corresponding to the minimum error in the first parameter group set obtained in the current iteration to the plurality of parameters in the photoresist model. In some other embodiments, the computer device compares the minimum error corresponding to the parameter group in the first parameter group set obtained in the current iteration with the minimum error corresponding to a parameter group in the first parameter group set obtained in a previous iteration, and when the minimum error corresponding to the parameter group in the first parameter group set obtained in the current iteration is less than or equal to the minimum error corresponding to the parameter group in the first parameter group set obtained in the previous iteration, performs the operation of respectively assigning the plurality of candidate values in the parameter group corresponding to the minimum error in the first parameter group set obtained in the current iteration to the plurality of parameters in the photoresist model. When the minimum error corresponding to the parameter group in the first parameter group set obtained in the current iteration is greater than the minimum error corresponding to the parameter group in the first parameter group set obtained in the previous iteration, the plurality of candidate values in the parameter group corresponding to the minimum error in the first parameter group set obtained in the previous iteration are respectively assigned to the plurality of parameters in the photoresist model. The photoresist model obtained in this way can predict a photoresist pattern closest to the reference photoresist pattern, that is, the photoresist model with higher accuracy can be obtained.

The embodiments of the present disclosure provide a method for determining a photoresist model for generating a photoresist pattern. In the method, a predicted photoresist pattern matrix of an existing parameter in a first parameter group set is determined through the photoresist model, and then degree of optimization of the second parameter group for the photoresist model is predicted based on an error between the predicted photoresist pattern matrix and a reference photoresist pattern matrix, so that a parameter group having good optimization degree in the second parameter groups can be selected to be added to the first parameter group set. According to the method, the first parameter group set is determined iteratively, and when a data volume in the first parameter group set is ensured, a parameter group which can effectively optimize a photoresist model can be found from the first parameter group set, thereby obtaining the photoresist model that can accurately predict a photoresist pattern. In addition, according to the method, a coefficient of the photoresist model is obtained by fitting the parameter group and the reference photoresist pattern, that is, the parameter and the coefficient of the photoresist model are optimized collaboratively, thereby improving accuracy of the photoresist model while ensuring optimization efficiency.

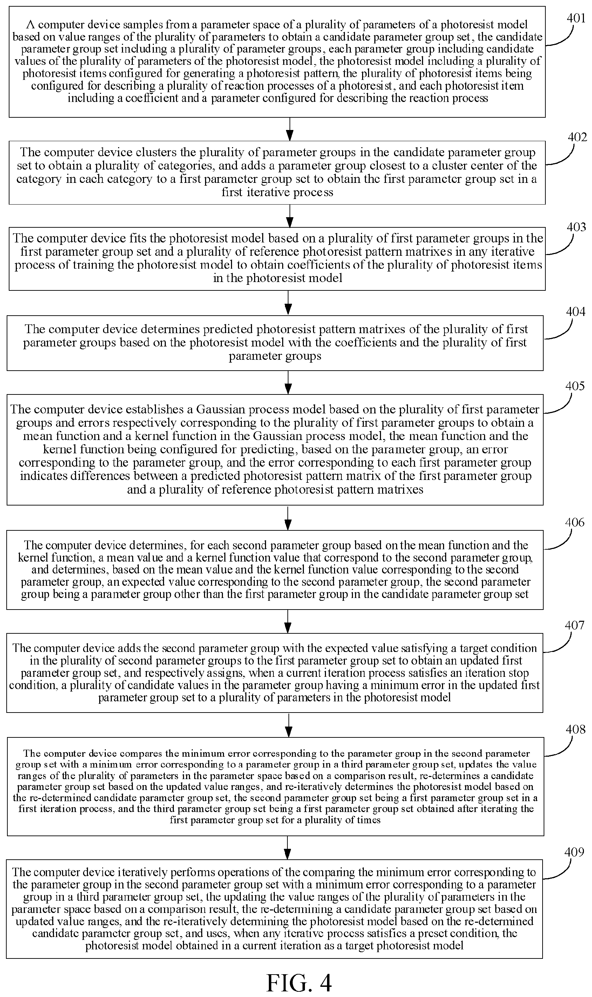

FIG. 3 describes a process of determining a photoresist model. In this process, a plurality of parameters corresponds to a value range, sampling is performed in parameter space once to obtain a candidate parameter group set, and iterative training is performed based on the candidate parameter group set obtained at this time, thereby determining the photoresist model. The following describes another process of determining a photoresist model based on FIG. 4. In this process, a value range of a plurality of parameters are iteratively adjusted, sampling is performed for a plurality of times based on the adjusted value range to iteratively update a candidate parameter group set, and the photoresist model is determined based on an updated candidate parameter group set. FIG. 4 is a flowchart of another method for determining a photoresist model for generating a photoresist pattern according to an embodiment of this application. The method is performed by the computer device. The method includes the following operations.

401: A computer device samples from a parameter space of a plurality of parameters of a photoresist model based on value ranges of the plurality of parameters to obtain a candidate parameter group set, the candidate parameter group set including a plurality of parameters, each parameter group including candidate values of the plurality of parameters of the photoresist model, the photoresist model including a plurality of photoresist items configured for generating a photoresist pattern, the plurality of photoresist items being configured for describing a plurality of reaction processes of a photoresist, and each photoresist item including a coefficient and a parameter configured for describing the reaction process.

402: The computer device clusters the plurality of parameters in the candidate parameter group set to obtain a plurality of categories, and adds a parameter group closest to a cluster center of the category in each category to a first parameter group set to obtain a first parameter group set in a first iterative process.

403: The computer device fits the photoresist model based on a plurality of first parameter groups in the first parameter group set and a plurality of reference photoresist pattern matrixes in any iterative process of training the photoresist model to obtain coefficients of the plurality of photoresist items in the photoresist model.

404: The computer device determines predicted photoresist pattern matrixes of the plurality of first parameter groups based on the photoresist model with the determined coefficients and the plurality of first parameter groups.

405: The computer device establishes a Gaussian process model based on the plurality of first parameter groups and errors respectively corresponding to the plurality of first parameter groups to obtain a mean function and a kernel function in the Gaussian process model, the mean function and the kernel function being configured for predicting, based on an input parameter group, an error corresponding to the input parameter group, and the error corresponding to each first parameter group indicates difference values between a predicted photoresist pattern matrix of the first parameter group and a plurality of reference photoresist pattern matrixes.

406: The computer device determines, for each second parameter group based on the mean function and the kernel function, a mean value and a kernel function value that correspond to the second parameter group, and determines, based on the mean value and the kernel function value corresponding to the second parameter group, an expected value corresponding to the second parameter group, the second parameter group being a parameter group other than the first parameter group in the candidate parameter group set.

407: The computer device adds a second parameter group with the expected value satisfying a target condition in the plurality of second parameter groups to the first parameter group set to obtain an updated first parameter group set, and respectively assigns, when a current iterative process satisfies an iteration stop condition, a plurality of candidate values in the parameter having a minimum error in the updated first parameter group set to a plurality of parameters in the photoresist model.

In this embodiment of this application, the foregoing operations 401 to 407 are the same as operations 301 to operation 307. Details are not described herein again.

408: The computer device compares the minimum error corresponding to the parameter group in the second parameter group set with a minimum error corresponding to a parameter group in a third parameter group set, updates the value ranges of the plurality of parameters in the parameter space based on a comparison result, re-determines a candidate parameter group set based on updated value ranges, and re-iteratively determines the photoresist model based on the re-determined candidate parameter group set, the second parameter group set being a first parameter group set in a first iterative process, and the third parameter group set being a first parameter group set obtained after iterating the first parameter group set for a plurality of times.

In this embodiment of this application, the third parameter group set is also referred as to the iterated model parameter group, the computer device re-determines the candidate parameter group set through operation 401, and re-iteratively determines the photoresist model based on the re-determined candidate parameter group set through operations 402 to 407.

In some embodiments, the process in which the computer device updates the value ranges of the plurality of parameters in the parameter space based on the comparison result includes the following operations: when the minimum error corresponding to the parameter group in the second parameter group set is less than or equal to the minimum error corresponding to the parameter group in the third parameter group set, the computer device reduces the value ranges of the plurality of parameters in the parameter space according to a preset proportion by using the parameter group corresponding to the minimum error in the second parameter group set as a center; or when the minimum error corresponding to the parameter group in the second parameter group set is greater than the minimum error corresponding to the parameter group in the third parameter group set, the computer device increases the value ranges of the plurality of parameters in the parameter space according to a preset proportion by using the parameter group corresponding to the minimum error in the third parameter group set as a center.

Value ranges of the plurality of parameters in the parameter space may be different. Correspondingly, for each parameter, the computer device reduces the value range of the parameter in the parameter space based on a value of the parameter in a target parameter group according to a preset proportion. The target parameter group is a parameter group corresponding to a minimum error in the second parameter group set or the third parameter group set. In this embodiment of this application, the preset proportion can be set and modified as required. This is not specifically limited herein. Optionally, the preset proportion is 50%.

In some embodiments, when reducing or increasing the value range of the parameter, the computer device constrains the value range of the parameter to be within a preset proper range. For example, thresholds of the truncation function max, that is, $t_1$ and $t_2$ in the formula (1) are constrained to be within a value range of (0, 1). Standard deviations of the Gaussian distribution function G, that is, $\delta_1, \delta_2, \delta_3, \delta_4$ and the like in the formula (1) are constrained to be greater than a pixel size, that is, a constraint is: $\delta > \lambda/(8NA)$. $\lambda$ represents a wave length of a light source of the photographing machine. NA represents a numerical aperture of the photographing machine.

In this embodiment of this application, when the minimum error corresponding to the parameter group in the second parameter group set is greater than or equal to the minimum error corresponding to the parameter group in the third parameter group set, it indicates that an optimal parameter group is not found within the value range of the current parameter space, then a parameter search range is reduced, and the value range of the plurality of parameters is reduced by using the parameter group corresponding to the current minimum error as a center, which is equivalent to reducing a search grid, and can improve a search density to find a better parameter group within the current value range. When the minimum error corresponding to the parameter group in the second parameter group set is less than the minimum error corresponding to the parameter group in the third parameter group set, it indicates that an optimal parameter group is found within the value range of the current parameter space, then the search range can be expanded, and the value range of the plurality of parameters is increased by using the parameter group corresponding to the current minimum error as a center, which is equivalent to expanding a search grid, and can find a better parameter group within a larger value range.

409: The computer device iteratively performs operations of the comparing the minimum error corresponding to the parameter group in the second parameter group set with a minimum error corresponding to a parameter group in a third parameter group set, the updating the value ranges of the plurality of parameters in the parameter space based on a comparison result, the re-determining a candidate parameter group set based on updated value ranges, and the re-iteratively determines the photoresist model based on the re-determined candidate parameter group set, and uses, when any iterative process satisfies a preset condition, the photoresist model obtained in a current iteration as a target photoresist model.

In this embodiment of this application, that any iterative process satisfies a preset condition refers to that a number of iterations in the iterative process reaches a target number of times or a minimum error obtained in the iterative process reaches an expected error value. The target number of times and the expected error value can be set and modified as required. This is not specifically limited herein.

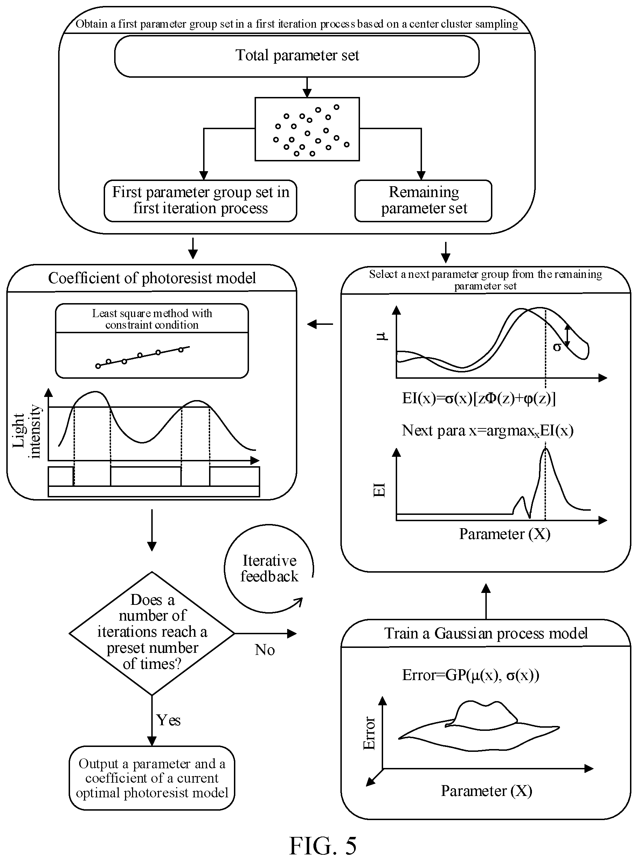

The method for determining a photoresist model for generating a photoresist pattern provided in this embodiment of the present disclosure includes the following operations. First operation: The computer device inputs a photoresist model and a parameter. The computer device inputs a mathematical form of the photoresist model, an initial value range of a plurality of parameters, a preset number of times, a number of iterations, and an expected error value. Second operation: The computer device performs sampling. The computer device performs sampling in parameter space in a hypercubic sampling mode or a random extraction mode. Third operation: The computer device optimizes a photoresist model parameter based on Bayesian active learning of center cluster sampling. For a flowchart that the computer device optimizes the photoresist model parameter based on Bayesian active learning of center cluster sampling, refer to FIG. 5. The process is an iterative process, and includes the following operations: (1) The computer device clusters sampled parameters by using a K-means algorithm, and selects parameter groups corresponding to N cluster centers to form a first parameter group set in a first iterative process. (2) The computer device obtains a coefficient in the photoresist model based on the parameter groups in the first parameter group set in combination with a least square method with a constraint condition. (3) The computer device calculates a root-mean-square error between a predicted photoresist pattern matrix of the plurality of parameters obtained through the photoresist model and a reference photoresist pattern matrix. A parameter group corresponding to a current minimum error is output when a number of iterations in any iterative process reaches a preset number of times; and otherwise, operation (4) is performed. (4) The computer device trains a machine learning agent model by using the plurality of parameters and root-mean-square errors respectively corresponding to the plurality of parameter groups as a training set, and trains by using a Gaussian process regression algorithm here, to obtain a Gaussian process model. (5) The computer device predicts a second parameter group by using the trained machine learning agent model to obtain a mean value and a kernel function value of the second parameter group, and then obtains an obtaining function. The obtaining function herein is an expected improvement function. The computer device finds parameter groups corresponding to a first target number of maximum obtaining functions in the second parameter group, and adds the parameter groups to the first parameter group set, to obtain the first parameter group set in a next iterative process. (6) The computer device repeatedly performs operation (2). Fourth operation: The computer device scales a grid of parameter space. When the minimum error is not reduced in the third operation, the value range of the plurality of parameters are reduced by half; and otherwise, the value ranges of the plurality of parameters are increased by twice. Then, the third operation is repeatedly performed until the number of iterations reaches a target number of times or the minimum error is less than the expected error value, a parameter group corresponding to the minimum error and the coefficient of the photoresist model are output, and a plurality of values in the parameter group are assigned to a plurality of parameters of the photoresist model to obtain a target photoresist model.

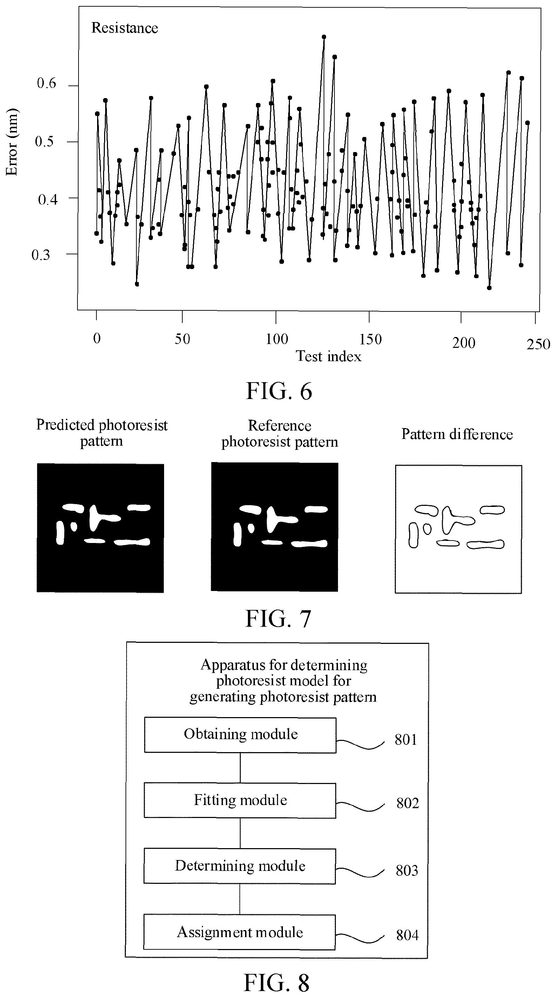

In some embodiments, the photoresist pattern matrix on a wafer predicted based on the target photoresist model determined by the method according to this embodiment of the present disclosure is compared with the reference photoresist pattern matrix, and a root-mean-square error between the photoresist pattern matrix and the reference photoresist pattern matrix is within a preset error range. For example, FIG. 6 is a schematic diagram of an error of a photoresist pattern matrix according to an embodiment of this application. An error between a predicted photoresist pattern matrix and a reference photoresist pattern matrix is within 1 nm, that is, an accurate photoresist pattern can be predicted through the photoresist model determined by the method according to the embodiments of this application.

For another example, FIG. 7 is a comparison diagram between a predicted photoresist pattern and a reference photoresist pattern according to an embodiment of this application. Three patterns in FIG. 7 are respectively the predicted photoresist pattern, the reference photoresist pattern, and a pattern obtained by making a difference between the two patterns. It can be learned from the figure that the predicted photoresist pattern is almost completely the same as the reference photoresist pattern. The reference photoresist pattern used in this embodiment of the present disclosure is a photoresist pattern of a logic type chip layout in a test set. According to the method according to this embodiment of this application, a photoresist model is determined, a parameter of an optimal photoresist model can be determined by a relatively low calculation amount, and manual parameter adjustment is almost not needed. That is, the photoresist model with high accuracy can be efficiently obtained by the method according to this embodiment of this application.

In some embodiments, to verify the method according to the embodiments of the present disclosure and apply the method to the photoresist model, a widely used public mask data set is selected as data to be used in the embodiments of this application. The light intensity distribution in the data set is obtained by using an optical model related to a part of an annular light source with a light source of 193 nm, and the reference photoresist pattern is obtained by using a threshold model.

In the method according to the embodiments of this application, a photoresist model parameter is optimized based on center cluster sampling and a scaling grid Bayesian active learning algorithm, and only a mathematical form of a photoresist model and an initial parameter value need to be input. The method can determine the photoresist model parameter that is globally optimal as much as possible, and further reduce a calculation amount required for modeling, parameter adjustment workload, and a required experimental measurement data amount. The method according to the embodiments of the present disclosure can significantly reduce the calculation amount and the parameter adjustment workload required for optimizing the photoresist model parameter. Further, a number of the photoresist items in the photoresist model can be optimized to further reduce an error of the photoresist model.

In a related technology, when deep learning training is performed based on light intensity distribution and a photoresist pattern to obtain a photoresist model, the accuracy of the photoresist model depends on a data volume. However, measurement data of an exposure pattern on a wafer is usually less and has high costs, making it difficult to put the solution to a place. However, only a coefficient of a photoresist item in the photoresist model can be determined by a lattice-point-dependent error method, and parameters in the photoresist model cannot be optimized. Therefore, a large amount of manual parameter adjustment is still needed. In the method according to the embodiments of this application, the photoresist model parameter is optimized based on center cluster sampling and a scaling grid Bayesian active learning algorithm. By using a Bayesian active learning machine proxy model, a mapping light of an overall error between experimental data of a parameter group set and reference, and a calculation result of a photoresist model is established, a scaling grid and an iterative sampling policy continuously optimize a photoresist model parameter, and continuously reduce an error. A globally optimal photoresist model parameter can be determined without a large amount of experimental measurement data, a calculation amount can be significantly reduced, and coefficients and parameters in a photoresist model can be cooperatively optimized.

According to the method provided in this embodiment of this application, in a process of determining a photoresist model, for a coefficient of each photoresist item in the photoresist model and a parameter in each photoresist item, the photoresist is optimized by using Bayesian active learning, and the coefficient of each photoresist item is determined by using a least square method with a constraint condition. For the problem that an optimization algorithm depends on initial value selection, global sampling is performed by using a center cluster sampling method, so that the Bayesian active learning optimization process is more efficient. For a problem that parameter space of parameters to be optimized is exceptionally large, optimization is performed on a coarse grid parameter space by using a scaling grid method, and then, optimization is continuously performed in fine grid parameter space near an extremum, which considers both a calculation amount and optimization efficiency, so that the photoresist pattern obtained by the photoresist model is increasingly close to an experimental measurement pattern. Without a large amount of experimental measurement data, a parameter of the photoresist model can be quickly determined, and a parameter having a minimum experimental measurement data error can be determined, significantly shortening optimization time. Therefore, by the method according to the embodiments of this application, coefficients and parameters of a photoresist model can be optimized collaboratively, and an optimal photoresist model parameter can be determined with a relatively low calculation amount and relatively high optimization efficiency. In some embodiments, by the method according to the embodiments of this application, an electronic design automation (EDA) calculation platform may be carried or combined with mainstream calculation photography software. A chip enterprise inputs a mathematical form of a photoresist model and initial parameter values, and an optimal photoresist model parameter may be obtained by the method according to the embodiments of this application, thereby significantly shortening calculation time, costs, parameter adjustment workload, and required experimental measurement data volume of the chip enterprise. Th method according to the embodiments of the present disclosure can further be extensively extended and applied to other links of an integrated circuit. For example, the method according to the embodiments of the present disclosure can further be applied to other fields of design and manufacturing, such as optimization of chip yield, optimization of an imaging system of a photographing machine, and optimization of a thermal transport performance of a chip.

FIG. 8 is a block diagram of an apparatus for determining a photoresist model for generating a photoresist pattern according to an embodiment of this application. The apparatus is configured to perform operations of the foregoing method for determining a photoresist model for generating a photoresist pattern. Referring to FIG. 8, the apparatus includes:

an obtaining module 801, configured to obtain a plurality of first parameter groups first parameter group set of a photoresist model in any iterative process of training the photoresist model, the photoresist model including a plurality of photoresist items configured for generating a photoresist pattern, each the plurality of photoresist items being configured for describing a plurality of reaction processes of a photoresist, each photoresist item including a coefficient and a parameter configured for describing the reaction process, and the first parameter group set being a subset of a candidate parameter group set;

a fitting module 802, configure to fit the photoresist model based on the plurality of first parameter groups and a plurality of reference photoresist pattern matrixes to obtain coefficients of the plurality of photoresist items in the photoresist model;

a determination module 803, configured to determine the determining predicted photoresist pattern matrixes of the plurality of first parameter groups based on the photoresist model with the determined coefficients and the plurality of first parameter groups, predict expected values of a plurality of second parameter groups in the candidate parameter group set based on the plurality of first parameter groups and errors respectively corresponding to the plurality of first parameter groups, and add a second parameter group with the expected value satisfying a target condition in the plurality of second parameter groups to the first parameter group set to obtain an updated first parameter group set, the expected value being configured to indicate degree of optimization of the photoresist model by the second parameter group, the error corresponding to each first parameter group indicating differences between the predicted photoresist pattern matrix of the first parameter group and the plurality of reference photoresist pattern matrixes, and the second parameter group being a parameter group other than the first parameter group in the candidate parameter group set; and

an assignment module 804, configured to: respectively assign, when a current iterative process satisfies an iteration stop condition, a plurality of candidate values in the parameter group having a minimum error in the updated first parameter group set to a plurality of parameters in the photoresist model.

In some embodiments, the determining module 803 is configured to:

establish a Gaussian process model based on the plurality of first parameter groups and the errors respectively corresponding to the plurality of first parameter groups to obtain a mean function and a kernel function in the Gaussian process model, the mean function and the kernel function being configured to predict, based on the an input parameter group, an error corresponding to the input parameter group;

determine, for each second parameter group based on the mean function and the kernel function, a mean value and a kernel function value that correspond to the second parameter group; and

determine the expected value corresponding to the second parameter group based on the mean value and the kernel function value that correspond to the second parameter group.

In some embodiments, the determining module 803 is configured to:
add a second parameter group with the expected value sorted in a first target digit in the plurality of second parameter groups to the first parameter group set.

In some embodiments, the determining module 803 is configured to:
add a second parameter group with the expected value greater than a preset expected value in the plurality of second parameter groups to the first parameter group set.

In some embodiments, the obtaining module 801 is configured to: cluster the plurality of parameter groups in the candidate parameter group set to obtain a plurality of categories, and add a parameter group closest to a cluster center of the category in each category to a first parameter group set to obtain the first parameter group set in a first iterative process.

In some embodiments, the fitting module 802 is configured to: perform least square fitting on the photoresist model based on the plurality of first parameter groups and the plurality of reference photoresist pattern matrixes to obtain the coefficients of the plurality of photoresist items.

In some embodiments, the apparatus further includes:

a difference value determining module, configured determine, for each first parameter group in the first parameter group set, differences between the predicted photoresist pattern matrix of the first parameter group and the plurality of reference photoresist pattern matrixes; and

a difference determining module, configured to use root-mean-square errors between a plurality of differences as the errors corresponding to the first parameter group, the plurality of differences being differences between the predicted photoresist pattern matrix of the first parameter group and the plurality of reference photoresist pattern matrixes.

In some embodiments, the apparatus further includes:

a sampling module, configured to sample from a parameter space of a plurality of parameters of the photoresist model based on value ranges of the plurality of parameters of the photoresist model to obtain the candidate parameter group set.

In some embodiments, the apparatus further includes:

a comparison module, configured to compare a minimum error corresponding to a parameter group in the second parameter group set with a minimum error corresponding to a parameter group in a third parameter group set, update the value ranges of the plurality of parameters in the parameter space based on a comparison result, re-determine a candidate parameter group set based on updated value ranges, and re-iteratively determine the photoresist model based on the re-determined candidate parameter group set, the second parameter group set being a first parameter group set in a first iterative process, and the third parameter group set being a first parameter group set obtained after iterating the first parameter group set for a plurality of times; and

an iteration module, configured to iteratively perform operations of comparing a minimum error corresponding to a parameter group in the second parameter group set with a minimum error corresponding to a parameter group in a third parameter group set, updating the value range of the plurality of parameters in the parameter space based on a comparison result, re-determining a candidate parameter group set based on updated value ranges, and re-iteratively determining the photoresist model based on the re-determined candidate parameter group set, and use, when any iterative process satisfies a preset condition, the photoresist model obtained in a current iteration as a target photoresist model.

In some embodiments, the comparison module is configured to:

reduce, when the minimum error corresponding to the parameter group in the second parameter group set is less than or equal to the minimum error corresponding to the parameter group in the third parameter group set, the value ranges of the plurality of parameters in the parameter space according to a preset proportion by using the parameter group corresponding to the minimum error in the second parameter group set as a center; and

increase, when the minimum error corresponding to the parameter group in the second parameter group set is greater than the minimum error corresponding to the parameter group in the third parameter group set, the value ranges of the plurality of parameters in the parameter space according to a preset proportion by using the parameter group corresponding to the minimum error in the third parameter group set as a center.

The embodiments of the present disclosure provide an apparatus for determining a photoresist model for generating a photoresist pattern. A predicted photoresist pattern matrix of an existing parameter in a first parameter group set is determined through the photoresist model, and then degree of optimization of the second parameter group for the photoresist model is predicted based on an error between the predicted photoresist pattern matrix and a reference photoresist pattern matrix, so that a parameter group having good optimization degree in the second parameter groups can be selected to be added to the first parameter group set. In this way, the first parameter group set is determined iteratively, and when a data volume in the first parameter group set is ensured, a parameter group which can effectively optimize a photoresist model can be found from the first parameter group set, thereby obtaining the photoresist model that can accurately predict a photoresist pattern. In addition, according to the method, a coefficient of the photoresist model is obtained by fitting the parameter group and the reference photoresist pattern, that is, the parameter and the coefficient of the photoresist model are optimized collaboratively, thereby improving accuracy of the photoresist model while ensuring optimization efficiency.

In the embodiments of this application, the computer device can be a terminal or a server. When the computer device is a terminal, the terminal is used as an execution body to implement a technical solution provided in the embodiments of this application. When the computer device is a server, the server is used as an execution body to implement a technical solution provided in the embodiments of this application. Or, the technical solution provided in the present disclosure is implemented through interaction between the terminal and the server. This is not limited in the embodiments of this application.

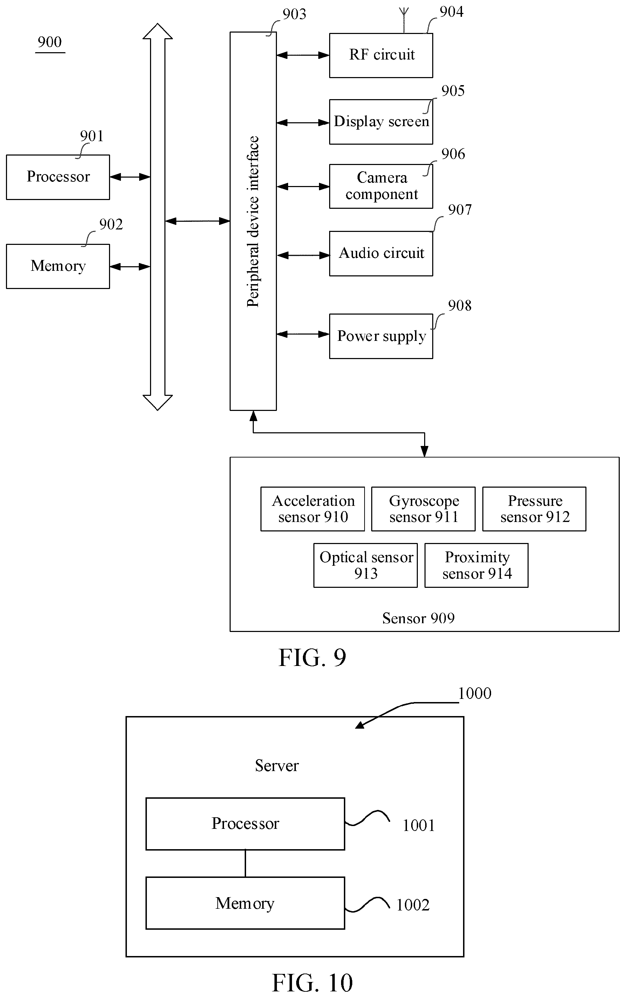

FIG. 9 is a structural block diagram of a terminal 900 according to an exemplary embodiment of this application.

Generally, the terminal 900 includes: a processor 901 and a memory 902.

The processor 901 may include one or more processing cores, for example, a 4-core processor or an 8-core processor. The processor 901 may be implemented in at least one hardware form of a digital signal processor (DSP), a field-programmable gate array (FPGA), and a programmable logic array (PLA). The processor 901 may alternatively include a main processor and a coprocessor. The main processor is a processor configured to process data in an awake state, and is alternatively referred to as a central processing unit (CPU). The coprocessor is a low power consumption processor configured to process the data in a standby state. In some embodiments, the processor 901 may be integrated with a graphics processing unit (GPU). The GPU is configured to render and draw content that needs to be displayed on a display screen. In some embodiments, the processor 901 may further include an artificial intelligence (AI) processor. The AI processor is configured to process computing operations related to machine learning.

The memory 902 may include one or more computer-readable storage media. The computer-readable storage medium may be non-transient. The memory 902 may further include a high-speed random access memory and a nonvolatile memory, for example, one or more disk storage devices or flash storage devices. In some embodiments, a non-transitory computer-readable storage medium in the memory 902 is configured to store at least one computer program, and the at least one computer program is executed by the processor 901 to implement the method for determining a photoresist model for generating a photoresist pattern according to the embodiments of this application.

In some embodiments, the terminal 900 further optionally includes: a peripheral device interface 903 and at least one peripheral device. The processor 901, the memory 902, and the peripheral device interface 903 may be connected through a bus or a signal line. Each peripheral device may be connected to the peripheral device interface 903 through a bus, a signal line, or a circuit board. Specifically, the peripheral device includes: at least one of a radio frequency (RF) circuit 904, a display screen 905, a camera component 906, an audio circuit 907, or a power supply 908.

The peripheral interface 903 may be configured to connect the at least one peripheral related to input/output (I/O) to the processor 901 and the memory 902. In some embodiments, the processor 901, the memory 902, and the peripheral device interface 903 are integrated on a same chip or circuit board. In some other embodiments, any or two of the processor 901, the memory 902, and the peripheral device interface 903 may be implemented on an independent chip or circuit board. This is not limited in the embodiments.

The RF circuit 904 is configured to receive and transmit an RF signal, also referred to as an electromagnetic signal. The RF circuit 904 communicates with a communication network and other communication devices through the electromagnetic signal. The RF circuit 904 converts an electric signal into an electromagnetic signal for sending, or converts a received electromagnetic signal into an electric signal. Optionally, the RF circuit 904 includes: an antenna system, an RF transceiver, one or more amplifiers, a tuner, an oscillator, a DSP, an encoding and decoding chipset, a user identity module card, and the like. The RF circuit 904 may communicate with other terminals through at least one wireless communication protocol. The wireless communication protocol includes, but is not limited to: the World Wide Web, a metropolitan area network, the Intranet, various generations of mobile communication networks (2G, 3G, 4G, and 5G), a wireless local area network, and/or a wireless fidelity (Wi-Fi) network. In some embodiments, the RF 904 may further include a circuit related to near field communication (NFC). This is not limited in this application.

The display screen 905 is configured to display a user interface (UI). The UI may include a pattern, text, an icon, a multimedia resource, and any combination thereof. When the display screen 905 is a touch display screen, the display screen 905 further has a capability of collecting a touch signal on or above a surface of the display screen 905. The touch signal may be input to the processor 901 as a control signal for processing. In this case, the display screen 905 may further be configured to provide a virtual button and/or a virtual keyboard that are/is also referred to as a soft button and/or a soft keyboard. In some embodiments, one display screen 905 may be arranged on a front panel of the terminal 900. In some other embodiments, there may be at least two display screens 905 respectively arranged on different surfaces of the terminal 900 or in a folded design. In some other embodiments, the display screen 905 may be a flexible display arranged on a curved surface or a folded surface of the terminal 900. Even, the display screen 905 may alternatively be arranged in a non-rectangular irregular pattern, that is, a special-shaped screen. The display screen 905 may be prepared by using a material such as a liquid crystal display (LCD), an organic light-emitting diode (OLED), or the like.

The camera component 906 is configured to collect an image or a multimedia resource. Optionally, the camera component 906 includes a front camera and a rear camera. Generally, the front camera is arranged on a front panel of a terminal, and the rear camera is arranged on a back surface of the terminal. In some embodiments, there are at least two rear cameras, which are respectively any of a main camera, a depth-of-field camera, a wide-angle camera, and a telephoto camera, to achieve background blur through fusion of the main camera and the depth-of-field camera, panoramic photographing and virtual reality (VR) photographing through fusion of the main camera and the wide-angle camera, or other fusion photographing functions. In some embodiments, the camera component 906 may further include a flash. The flash may be a monochrome temperature flash, or may be a double-color temperature flash. The double color temperature flash refers to a combination of a warm light flash and a cold light flash, and may be used for light compensation under different color temperatures.

The audio circuit 907 may include a microphone and a speaker. The microphone is configured to collect sound waves of a user and an environment, and convert the sound waves into an electrical signal to input to the processor 901 for processing, or input to the RF circuit 904 for implementing voice communication. For the purpose of stereo sound collection or noise reduction, there may be a plurality of microphones, respectively arranged at different parts of the terminal 900. The microphone may further be an array microphone or an omni-directional acquisition type microphone. The speaker is configured to convert the electrical signal from the processor 901 or the RF circuit 904 into sound waves. The speaker may be a conventional film speaker, or may be a piezoelectric ceramic speaker. When the speaker is the piezoelectric ceramic speaker, the speaker not only can convert an electric signal into acoustic waves audible to a human being, but also can convert an electric signal into acoustic waves inaudible to a human being, for ranging and other purposes. In some embodiments, the audio circuit 907 may further include an earphone jack.

The power supply 908 is configured to supply power to various components in the terminal 900. The power supply 908 may be an alternating current battery, a direct current battery, a primary battery, or a rechargeable battery. When the power supply 908 includes a rechargeable battery, and the rechargeable battery may be a wired rechargeable battery or a wireless rechargeable battery. The wired rechargeable battery is a battery charged through a wired circuit, and the wireless rechargeable battery is a battery charged through a wireless coil. The rechargeable battery may alternatively be configured to support a fast charge technology.

In some embodiments, the terminal 900 further includes one or more sensors 909. The one or more sensors 909 include, but are not limited to: an acceleration sensor 910, a gyroscope sensor 911, a pressure sensor 912, an optical sensor 913, and a proximity sensor 914.

The acceleration sensor 910 may detect a magnitude of acceleration on three coordinate axes of a coordinate system established with the terminal 900. For example, the acceleration sensor 910 may be configured to detect components of gravity acceleration on the three coordinate axes. The processor 901 may control, according to a gravity acceleration signal collected by the acceleration sensor 910, the display screen 905 to display the user interface in a landscape view or a portrait view. The acceleration sensor 910 may alternatively be configured to collect motion data of a game or a user.

The gyroscope sensor 911 may detect a body direction and a rotation angle of the terminal 900. The gyroscope sensor 911 may cooperate with the acceleration sensor 910 to collect a 3D action by the user on the terminal 900. The processor 901 may implement the following functions according to the data collected by the gyroscope sensor 911: motion sensing (such as changing the UI according to a tilt operation of the user), image stabilization at shooting, game control, and inertial navigation.

The pressure sensor 912 may be arranged at a side frame of the terminal 900 and/or a lower layer of the display screen 905. When the pressure sensor 912 is arranged at the side frame of the terminal 900, a holding signal of the user on the terminal 900 may be detected. The processor 901 performs left and right hand recognition or a quick operation according to the holding signal collected by the pressure sensor 912. When the pressure sensor 912 is arranged on the low layer of the display screen 905, the processor 901 controls, according to a pressure operation of the user on the display screen 905, an operable control on the UI. The operable control includes at least one of a button control, a scroll-bar control, an icon control, and a menu control.

The optical sensor 913 is configured to collect ambient light intensity. In an embodiment, the processor 901 may control display brightness of the display screen 905 according to the ambient light intensity collected by the optical sensor 913. Specifically, when the ambient light intensity is relatively high, the display brightness of the display screen 905 is increased; and when the ambient light intensity is relatively low, the display brightness of the display screen 905 is decreased. In another embodiment, the processor 901 may further dynamically adjust a shooting parameter of the camera component 906 according to the ambient light intensity collected by the optical sensor 913.

The proximity sensor 914, alternatively referred to as a distance sensor, is generally arranged on the front panel of the terminal 900. The proximity sensor 914 is configured to collect a distance between the user and a front surface of the terminal 900. In an embodiment, when the proximity sensor 914 detects that the distance between the user and the front surface of the terminal 900 gradually decreases, the display screen 905 is controlled by the processor 901 to switch from a screen-on state to a screen-off state. When the proximity sensor 914 detects that the distance between the user and the front surface of the terminal 900 gradually increases, the touch screen 901 is controlled by the display screen 905 to switch from the screen-off state to the screen-on state.

A person skilled in the art may understand that the structure shown in FIG. 9 does not constitute a limitation on the terminal 900, and more or fewer components than those shown in the figure may be included, or some components may be combined, or a different component deployment may be used.

FIG. 10 is a schematic structural diagram of a server according to an embodiment of this application. A server 1000 may vary considerably depending on configuration or performance, and can include one or more central processing units (CPUs) 1001 and one or more memories 1002. The memory 1002 is configured to store a computer program. The processor 1001 is configured to execute the foregoing computer program to implement the method for determining a photoresist model for generating a photoresist pattern provided in various method embodiments described above. Certainly, the server can further have components such as a wired or wireless network interface, a keyboard, and an I/O interface for inputting and outputting. The server can further include another component for achieving a device function. Details are not described herein.

The embodiments of the present disclosure further provide a computer-readable storage medium. The computer-readable storage medium is configured to store at least one computer program. The at least one computer program is loaded and executed by a processor to implement the method for determining a photoresist model for generating a photoresist pattern according to any implementation described above.

The embodiments of the present disclosure further provide a computer program product. The computer program product includes a computer program. The computer program is stored in a computer-readable storage medium, and a processor of a computer device reads the computer program from the computer-readable storage medium and executes the computer program, to enable the computer device to perform a method for determining a photoresist model for generating a photoresist pattern according to any implementation described above.

In some embodiments, the computer program product involved in the embodiments of the present disclosure may be deployed on a computer device for execution, or may be executed on a plurality of computer devices located at one location, or may be executed on a plurality of computer devices distributed at a plurality of locations and connected by a communication network. The plurality of computer devices distributed at the plurality of locations and connected by the communication network can form a blockchain system.

The foregoing descriptions are merely optional embodiments of this application, but are not intended to limit this application. Any modification, equivalent replacement, or improvement made within the spirit and principle of the present disclosure fall within the scope of protection of this application.

**Claims**

1.  A method for determining a photoresist model for generating a photoresist pattern, performed by a computer device, the method comprising:

    obtaining a plurality of model parameters from a model parameter group of a photoresist model in a current iterative process of training the photoresist model, wherein the photoresist model comprises a plurality of pattern modules configured to generate a photoresist pattern, each of the plurality of pattern modules corresponds to a respective reaction process of a plurality of photoresist reaction processes;
    fitting the plurality of model parameters and reference pattern matrixes to obtain a coefficient of each of the plurality of pattern modules in the photoresist model;
    determining a predicted pattern matrix of each of the plurality of model parameters using the coefficient of each of the plurality of pattern modules in the photoresist model, predicting a optimization expected value of each of a plurality of candidate model parameters using difference between the predicted pattern matrix of each of the plurality of model parameters and the reference pattern matrixes, wherein the optimization expected value indicates degree of optimization of the candidate model parameter for the photoresist model, and adding a target candidate model parameter with the optimization expected value satisfying a target condition among the plurality of candidate model parameters to the model parameter group to update the model parameter group; and
    in response to that the current iterative process satisfies an iteration stop condition, respectively assigning each of a plurality of candidate values in a parameter having a minimum difference in the updated model parameter group to a respective parameter of a plurality of parameters in the photoresist model.

2.  The method of claim 1, wherein predicting the optimization expected value of each of the plurality of candidate model parameters using difference between the predicted pattern matrix of each of the plurality of model parameters and the reference pattern matrixes comprises:

    establishing a Gaussian process model using the plurality of model parameters and the difference between the predicted pattern matrix of each of the plurality of model parameters and the reference pattern matrixes to obtain a mean function and a kernel function in the Gaussian process model, wherein the mean function and the kernel function is used to predict, using an input parameter, difference corresponding to the input parameter;

for each of the plurality of candidate model parameters, determining, using the mean function and the kernel function, a mean value and a kernel function value of the candidate model parameter; and

determining the optimization expected value of the candidate model parameter using the mean value and the kernel function value of the candidate model parameter.

3. The method of claim 2, wherein adding the target candidate model parameter with the optimization expected value satisfying a target condition among the plurality of candidate model parameters to the model parameter group comprises:

adding a candidate model parameter with the optimization expected value sorted in a first target digit among the plurality of candidate model parameters to the model parameter group.

4. The method of claim 2, wherein adding the target candidate model parameter with the optimization expected value satisfying a target condition among the plurality of candidate model parameters to the model parameter group comprises:

adding a candidate model parameter with the optimization expected value greater than a preset optimization expected value among the plurality of candidate model parameters to the model parameter group.

5. The method of claim 1, wherein obtaining the model parameter group in a first iterative process comprises:

clustering a plurality of parameters in the candidate parameter group to obtain a plurality of categories; and adding a parameter closest to a cluster center of the category in each category to the model parameter group to obtain the model parameter group in the first iterative process.

6. The method of claim 1, wherein fitting the plurality of model parameters and the reference pattern matrixes to obtain the coefficient of each of the plurality of pattern modules in the photoresist model comprises:

performing least square fitting on the plurality of model parameters and the reference pattern matrixes to obtain the coefficient of each of the plurality of pattern modules.

7. The method of claim 1, further comprising:

for each of the plurality of model parameters in the model parameter group, determining difference values between the predicted pattern matrix of the model parameter and the plurality of reference pattern matrixes; and determining a root-mean-square error among the plurality of difference values as the difference corresponding to the model parameter, wherein each of the plurality of difference values is a difference value between the predicted pattern matrix of the model parameter and each of the plurality of reference pattern matrixes.

8. The method of claim 1, further comprising:

sampling from a parameter space of the plurality of parameters in the photoresist model using value ranges of the plurality of parameters to obtain the candidate parameter group.

9. The method of claim 8, wherein after in response to that the current iterative process satisfies an iteration stop condition, respectively assigning, each of a plurality of candidate values in a model parameter having a minimum difference in the updated model parameter group to a respective parameter of a plurality of parameters in the photoresist model comprises:

comparing a minimum difference corresponding to a parameter in the candidate model parameter group with a minimum difference corresponding to a parameter in a iterated model parameter group, updating the value ranges of the plurality of parameters in the parameter space using a comparison result, re-determining a candidate parameter group using updated value ranges, and re-iteratively determining the photoresist model using the re-determined candidate parameter group, wherein the candidate model parameter group is a model parameter group in a first iterative process, and the iterated model parameter group is a model parameter group obtained after iterating the model parameter group for a plurality of times; and iteratively performing operations of comparing a minimum difference corresponding to a parameter in the candidate model parameter group with a minimum difference corresponding to a parameter in a iterated model parameter group, updating the value ranges of the plurality of parameters in the parameter space using a comparison result, re-determining a candidate parameter group using updated value ranges, and re-iteratively determining the photoresist model using the re-determined candidate parameter group, and using, when the current iterative process satisfies a preset condition, the photoresist model obtained in the current iteration as a target photoresist model.

10. The method of claim 9, wherein updating the value ranges of the plurality of parameters in the parameter space using the comparison result comprises:

reducing, when the minimum difference corresponding to the parameter in the candidate model parameter group is less than or equal to the minimum difference corresponding to the parameter in the iterated model parameter group, the value ranges of the plurality of parameters in the parameter space according to a preset proportion by using the parameter corresponding to the minimum difference in the candidate model parameter group as a center; or

increasing, when the minimum difference corresponding to the parameter in the candidate model parameter group is greater than the minimum difference corresponding to the parameter group in the iterated model parameter group, the value ranges of the plurality of parameters in the parameter space according to a preset proportion by using the parameter corresponding to the minimum difference in the iterated model parameter group as a center.

11. An apparatus for determining a photoresist model for generating a photoresist pattern, comprising:

an obtaining module, configured to obtain a plurality of model parameters from a model parameter group of a photoresist model in a current iterative process of training the photoresist model, wherein the photoresist model comprises a plurality of pattern modules configured for generating a photoresist pattern, each of the plurality of pattern modules corresponds to a respective reaction process of a plurality of photoresist reaction processes;

a fitting module, configure to fit the plurality of model parameters and reference pattern matrixes to obtain a coefficient of each of the plurality of pattern modules in the photoresist model;

a determining module, configured determine a predicted pattern matrix of each of the plurality of model parameters using the coefficients, predict a optimization expected value of each of a plurality of candidate model parameters using difference between the predicted pattern matrix of each of the plurality of model parameters and the reference pattern matrixes, wherein the optimization expected value indicates degree of optimization of the candidate model parameter for the photoresist model, and add a target candidate model parameter with the optimization expected value satisfying a target condition among the plurality of candidate model parameters to the model parameter group to update the model parameter group; and

an assignment module, configured to: in response to that the current iterative process satisfies an iteration stop condition, respectively assign each of a plurality of candidate values in a parameter having a minimum difference in the updated model parameter group to a respective parameter of a plurality of parameters in the photoresist model.

12. A computer device, comprising a processor and a memory, the memory being configured to store at least one computer program, and the at least one computer program being loaded and executed by the processor to perform the method for determining a photoresist model for generating a photoresist pattern of any one of claims 1 to 10.

13. A computer-readable storage medium having stored therein at least one computer program that, when executed by a processor of a computer device, causes the computer device to perform the method for determining a photoresist model for generating a photoresist pattern of any one of claims 1 to 10.

14. A computer program product, comprising a computer program, the computer program being stored in a computer-readable storage medium, a processor of a computer device reading the computer program from the computer-readable storage medium, and the processor executing the computer program, to enable the computer device to perform the method for determining a photoresist model for generating a photoresist pattern of any one of claims 1 to 10.

FIG. 1

A computer device obtains, in any iterative process of training a photoresist model, a plurality of first parameter groups from a first parameter group set of the photoresist model, the photoresist model including a plurality of photoresist items configured for generating a photoresist pattern, the plurality of photoresist items being configured for describing a plurality of reaction processes of a photoresist, each photoresist item including a coefficient and a parameter configured for describing the reaction process, and the first parameter group set being a subset of a candidate parameter group set

201

The computer device fits the photoresist model based on the plurality of first parameter groups and a plurality of reference photoresist pattern matrixes to obtain coefficients of the plurality of photoresist items in the photoresist model

202

The computer device determines predicted photoresist pattern matrixes of the plurality of first parameter groups based on the photoresist model with the coefficients and the plurality of first parameter groups, predicts expected values of a plurality of second parameter groups in the candidate parameter group set based on the plurality of first parameter groups and errors respectively corresponding to the plurality of first parameter groups, and adds the second parameter group with the expected value satisfying a target condition in the plurality of second parameter groups to the first parameter group set to obtain an updated first parameter group set, the expected values being configured for indicating degree of optimization of the second parameter group for the photoresist model, the respective error corresponding to each first parameter group indicating differences between the predicted photoresist pattern matrix of the first parameter group and the plurality of reference photoresist pattern matrixes, and the second parameter group being a parameter group other than the first parameter group in the candidate parameter group set

203

The computer device respectively assigns, when a current iteration process satisfies an iteration stop condition, a plurality of candidate values in a parameter group having a minimum error in the updated first parameter group set to a plurality of parameters in the photoresist model

204

FIG. 2

A computer device samples from a parameter space of a plurality of parameters of a photoresist model based on value ranges of the plurality of parameters to obtain a candidate parameter group set, the candidate parameter group set including a plurality of parameter groups, each parameter group including candidate values of the plurality of parameters of the photoresist model, the photoresist model including a plurality of photoresist items configured for generating a photoresist pattern, each photoresist item being configured for describing a plurality of reaction processes of a photoresist, and each photoresist item including a coefficient and a parameter configured for describing the reaction process

301

The computer device clusters the plurality of parameter groups in the candidate parameter group set to obtain a plurality of categories, and adds a parameter group closest to a cluster center of the category in each category to a first parameter group set to obtain the first parameter group set in a first iterative process

302

The computer device fits the photoresist model based on a plurality of first parameter groups in the first parameter group set and a plurality of reference photoresist pattern matrixes in any iterative process of training the photoresist model to obtain coefficients of the plurality of photoresist items in the photoresist model

303

The computer device determines predicted photoresist pattern matrixes of the plurality of first parameter groups based on the photoresist model with the coefficients and the plurality of first parameter groups

304

The computer device establishes a Gaussian process model based on the plurality of first parameter groups and errors respectively corresponding to the plurality of first parameter groups to obtain a mean function and a kernel function in the Gaussian process model, the mean function and the kernel function being configured for predicting, based on an input parameter group, an error corresponding to the input parameter group, and the error corresponding to each first parameter group indicating differences between a predicted photoresist pattern matrix of the first parameter group and a plurality of reference photoresist pattern matrixes

305

The computer device determines, for each second parameter group based on the mean function and the kernel function, a mean value and a kernel function value that correspond to the second parameter group, and determines, based on the mean value and the kernel function value corresponding to the second parameter group, an expected value corresponding to the second parameter group, the second parameter group being a parameter group other than the first parameter group in the candidate parameter group set

306

The computer device adds the second parameter group with the expected value satisfying a target condition in the plurality of second parameter groups to the first parameter group set to obtain an updated first parameter group set, and respectively assigns, when a current iteration process satisfies an iteration stop condition, a plurality of candidate values in the parameter group having a minimum error in the updated first parameter group set to a plurality of parameters in the photoresist model

307

FIG. 3

A computer device samples from a parameter space of a plurality of parameters of a photoresist model based on value ranges of the plurality of parameters to obtain a candidate parameter group set, the candidate parameter group set including a plurality of parameter groups, each parameter group including candidate values of the plurality of parameters of the photoresist model, the photoresist model including a plurality of photoresist items configured for generating a photoresist pattern, the plurality of photoresist items being configured for describing a plurality of reaction processes of a photoresist, and each photoresist item including a coefficient and a parameter configured for describing the reaction process

401

The computer device clusters the plurality of parameter groups in the candidate parameter group set to obtain a plurality of categories, and adds a parameter group closest to a cluster center of the category in each category to a first parameter group set to obtain the first parameter group set in a first iterative process

402

The computer device fits the photoresist model based on a plurality of first parameter groups in the first parameter group set and a plurality of reference photoresist pattern matrixes in any iterative process of training the photoresist model to obtain coefficients of the plurality of photoresist items in the photoresist model

403

The computer device determines predicted photoresist pattern matrixes of the plurality of first parameter groups based on the photoresist model with the coefficients and the plurality of first parameter groups

404

The computer device establishes a Gaussian process model based on the plurality of first parameter groups and errors respectively corresponding to the plurality of first parameter groups to obtain a mean function and a kernel function in the Gaussian process model, the mean function and the kernel function being configured for predicting, based on the parameter group, an error corresponding to the parameter group, and the error corresponding to each first parameter group indicates differences between a predicted photoresist pattern matrix of the first parameter group and a plurality of reference photoresist pattern matrixes

405

The computer device determines, for each second parameter group based on the mean function and the kernel function, a mean value and a kernel function value that correspond to the second parameter group, and determines, based on the mean value and the kernel function value corresponding to the second parameter group, an expected value corresponding to the second parameter group, the second parameter group being a parameter group other than the first parameter group in the candidate parameter group set

406

The computer device adds the second parameter group with the expected value satisfying a target condition in the plurality of second parameter groups to the first parameter group set to obtain an updated first parameter group set, and respectively assigns, when a current iteration process satisfies an iteration stop condition, a plurality of candidate values in the parameter group having a minimum error in the updated first parameter group set to a plurality of parameters in the photoresist model

407

The computer device compares the minimum error corresponding to the parameter group in the second parameter group set with a minimum error corresponding to a parameter group in a third parameter group set, updates the value ranges of the plurality of parameters in the parameter space based on a comparison result, re-determines a candidate parameter group set based on the updated value ranges, and re-iteratively determines the photoresist model based on the re-determined candidate parameter group set, the second parameter group set being a first parameter group set in a first iteration process, and the third parameter group set being a first parameter group set obtained after iterating the first parameter group set for a plurality of times

408

The computer device iteratively performs operations of the comparing the minimum error corresponding to the parameter group in the second parameter group set with a minimum error corresponding to a parameter group in a third parameter group set, the updating the value ranges of the plurality of parameters in the parameter space based on a comparison result, the re-determining a candidate parameter group set based on updated value ranges, and the re-iteratively determining the photoresist model based on the re-determined candidate parameter group set, and uses, when any iterative process satisfies a preset condition, the photoresist model obtained in a current iteration as a target photoresist model

409

FIG. 4

Obtain a first parameter group set in a first iteration process based on a center cluster sampling

Total parameter set

First parameter group set in first iteration process

Remaining parameter set

Coefficient of photoresist model

Least square method with constraint condition

Light intensity

Select a next parameter group from the remaining parameter set

$\mu$

$\sigma$

$$EI(x)=\sigma(x)[z\Phi(z)+\varphi(z)]$$

$$\text{Next para } x=\text{argmax}_x EI(x)$$

EI

Parameter (X)

Iterative feedback

Does a number of iterations reach a preset number of times?

No

Yes

Output a parameter and a coefficient of a current optimal photoresist model

Train a Gaussian process model

$$Error=GP(\mu(x), \sigma(x))$$

Error

Parameter (X)

FIG. 5

FIG. 6

Predicted photoresist pattern

Reference photoresist pattern

Pattern difference

FIG. 7

Apparatus for determining photoresist model for generating photoresist pattern

Obtaining module — 801

Fitting module — 802

Determining module — 803

Assignment module — 804

FIG. 8

900

901
Processor

902
Memory

903
Peripheral device interface

904
RF circuit

905
Display screen

906
Camera component

907
Audio circuit

908
Power supply

Acceleration sensor 910 | Gyroscope sensor 911 | Pressure sensor 912

Optical sensor 913 | Proximity sensor 914

Sensor 909

FIG. 9

1000

Server

Processor    1001

Memory    1002

FIG. 10

## INTERNATIONAL SEARCH REPORT

| International application No. |
| --- |
| **PCT/CN2023/131292** |

**A. CLASSIFICATION OF SUBJECT MATTER**

G03F7/20(2006.01)i

According to International Patent Classification (IPC) or to both national classification and IPC

**B. FIELDS SEARCHED**

Minimum documentation searched (classification system followed by classification symbols)

IPC:G03F

Documentation searched other than minimum documentation to the extent that such documents are included in the fields searched

Electronic data base consulted during the international search (name of data base and, where practicable, search terms used)

CNTXT, ENTXTC, ENTXT, CNKI: 光刻胶, 光致抗蚀剂, 光抗蚀剂, 模型, 物理, 化学, 反应, 矩阵, 像素, 误差, 差值, photoresist, model, react+, response, matrix, array, pattern, image, pixel, element.

**C. DOCUMENTS CONSIDERED TO BE RELEVANT**

| Category* | Citation of document, with indication, where appropriate, of the relevant passages | Relevant to claim No. |
| --- | --- | --- |
| A | US 2020027021 A1 (SASTRY Kumara.et al.) 23 January 2020 (2020-01-23) description, paragraphs [0040]-[0081], and figures 5-13 | 1-14 |
| A | CN 112005347 A (LAM RESEARCH CORP.) 27 November 2020 (2020-11-27) entire document | 1-14 |
| A | CN 1869818 A (ASML MASKTOOLS B.V.) 29 November 2006 (2006-11-29) entire document | 1-14 |
| A | CN 115729052 A (ASML NETHERLANDS B.V.) 03 March 2023 (2023-03-03) entire document | 1-14 |
| A | CN 109073985 A (TOKYO ELECTRON LTD.) 21 December 2018 (2018-12-21) entire document | 1-14 |
| A | CN 115587545 A (GUANGZHOU CANSEMI TECHNOLOGY CO., LTD. et al.) 10 January 2023 (2023-01-10) entire document | 1-14 |

☑ Further documents are listed in the continuation of Box C. ☑ See patent family annex.

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| **17 January 2024** | **03 February 2024** |

| Name and mailing address of the ISA/CN | Authorized officer |
| --- | --- |
| **China National Intellectual Property Administration (ISA/ CN)** **China No. 6, Xitucheng Road, Jimenqiao, Haidian District, Beijing 100088** | |
| | Telephone No. |

Form PCT/ISA/210 (second sheet) (July 2022)

**INTERNATIONAL SEARCH REPORT**

| International application No. |
| --- |
| **PCT/CN2023/131292** |

**C.    DOCUMENTS CONSIDERED TO BE RELEVANT**

| Category* | Citation of document, with indication, where appropriate, of the relevant passages | Relevant to claim No. |
| --- | --- | --- |
| A | CN 101256362 A (SHANGHAI HUAHONG NEC ELECTRONICS CO., LTD.) 03 September 2008 (2008-09-03) entire document | 1-14 |

Form PCT/ISA/210 (second sheet) (July 2022)

**INTERNATIONAL SEARCH REPORT**
Information on patent family members

International application No.

**PCT/CN2023/131292**

| Patent document cited in search report | | | Publication date (day/month/year) | Patent family member(s) | | | Publication date (day/month/year) |
|---|---|---|---|---|---|---|---|
| US | 2020027021 | A1 | 23 January 2020 | None | | | |
| CN | 112005347 | A | 27 November 2020 | TW | 202006817 | A | 01 February 2020 |
| | | | | US | 2023205076 | A1 | 29 June 2023 |
| | | | | KR | 20200131342 | A | 23 November 2020 |
| | | | | WO | 2019199697 | A1 | 17 October 2019 |
| | | | | US | 2021157228 | A1 | 27 May 2021 |
| | | | | US | 11624981 | B2 | 11 April 2023 |
| CN | 1869818 | A | 29 November 2006 | TW | 200723034 | A | 16 June 2007 |
| | | | | TWI | 334985 | B | 21 December 2010 |
| | | | | JP | 2006210936 | A | 10 August 2006 |
| | | | | JP | 4427518 | B2 | 10 March 2010 |
| | | | | US | 2006208205 | A1 | 21 September 2006 |
| | | | | US | 7494753 | B2 | 24 February 2009 |
| | | | | SG | 124406 | A1 | 30 August 2006 |
| | | | | KR | 20060087446 | A | 02 August 2006 |
| | | | | EP | 1688795 | A2 | 09 August 2006 |
| | | | | EP | 1688795 | A3 | 12 December 2007 |
| | | | | CN | 100576084 | C | 30 December 2009 |
| | | | | SG | 124406 | B | 30 January 2009 |
| CN | 115729052 | A | 03 March 2023 | WO | 2023030807 | A1 | 09 March 2023 |
| CN | 109073985 | A | 21 December 2018 | TW | 201738788 | A | 01 November 2017 |
| | | | | TWI | 651623 | B | 21 February 2019 |
| | | | | US | 2017242344 | A1 | 24 August 2017 |
| | | | | US | 10048594 | B2 | 14 August 2018 |
| | | | | WO | 2017143166 | A1 | 24 August 2017 |
| | | | | KR | 20180110138 | A | 08 October 2018 |
| | | | | JP | 2019507383 | A | 14 March 2019 |
| | | | | JP | 7064080 | B2 | 10 May 2022 |
| | | | | CN | 109073985 | B | 09 November 2021 |
| CN | 115587545 | A | 10 January 2023 | CN | 115587545 | B | 07 April 2023 |
| CN | 101256362 | A | 03 September 2008 | CN | 101256362 | B | 21 July 2010 |

Form PCT/ISA/210 (patent family annex) (July 2022)

**REFERENCES CITED IN THE DESCRIPTION**

**Patent documents cited in the description**

- CN 202310371665